(19) Europäisches Patentamt
European Patent Office
Office européen des brevets

(11) EP 2 738 864 B1

(12) **EUROPEAN PATENT SPECIFICATION**

(45) Date of publication and mention of the grant of the patent:
**01.03.2017 Bulletin 2017/09**

(21) Application number: **12819210.1**

(22) Date of filing: **27.07.2012**

(51) Int Cl.:
***H01G 9/20*** (2006.01) ***C09B 57/00*** (2006.01)

(86) International application number:
**PCT/JP2012/069181**

(87) International publication number:
**WO 2013/018711 (07.02.2013 Gazette 2013/06)**

# (54) PIGMENT SENSITIZATION SOLAR CELL

PIGMENTSENSIBILISIERUNGSSOLARZELLE

CELLULE SOLAIRE SENSIBILISÉE PAR PIGMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.07.2011 JP 2011166664**

(43) Date of publication of application:
**04.06.2014 Bulletin 2014/23**

(73) Proprietor: **Toppan Printing Co., Ltd.**
**Tokyo 110-8560 (JP)**

(72) Inventors:
- **SHIBAYAMA, Naoyuki**
**Tokyo 110-8560 (JP)**
- **ABE, Masahiro**
**Tokyo 110-8560 (JP)**

(74) Representative: **Andrews, Timothy Stephen**
**Marks & Clerk LLP**
**62-68 Hills Road**
**Cambridge**
**Cambridgeshire CB2 1LA (GB)**

(56) References cited:
**JP-A- 2007 234 580** **JP-A- 2009 032 547**
**JP-A- 2012 144 447** **US-A1- 2009 217 979**

- **YOUSUKE OOYAMA ET AL: "Dye-Sensitized Solar Cells Based On Donor-Acceptor [pi]-Conjugated Fluorescent Dyes with a Pyridine Ring as an Electron-Withdrawing Anchoring Group", ANGEWANDTE CHEMIE INTERNATIONAL EDITION, vol. 50, no. 32, 29 June 2011 (2011-06-29) , pages 7429-7433, XP055029227, ISSN: 1433-7851, DOI: 10.1002/anie.201102552**
- **YOSUKE OYAMA ET AL.: 'Carboxyl-ki o Hitsuyo to shinai Shingata D-n-A Yukiko Zokan Shikiso no Sosei to Shikiso Zokan Taiyo Denchi eno Oyo' 91ST ANNUAL MEETING OF THE CHEMICAL SOCIETY OF JAPAN IN SPRING (2011) KOEN YOKOSHU II 11 March 2011, pages 512 - 3G5-03, XP008172933**
- **TOMOYA NAGANO ET AL.: 'Pyridine-kan o Acceptor katsu Koteiki to shite Yusuru D-n-A-gata Keikosei Shikiso o Mochiita Shikiso Zokan Taiyo Denchi' 91ST ANNUAL MEETING OF THE CHEMICAL SOCIETY OF JAPAN IN SPRING (2011) KOEN YOKOSHU II 11 March 2011, pages 612 - 2PB-100, XP008172934**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 738 864 B1

**Description**

TECHNICAL FIELD

The present invention relates to a dye-sensitized solar cell, and particularly to a highly efficient dye-sensitized solar cell in which a plurality of sensitizing dyes are used.

BACKGROUND ART

A solar cell that uses solar light as an energy source instead of a fossil fuel is attracting attention, and a variety of studies are being made. The solar cell is one of photoelectric conversion devices that convert light energy into electric energy, and has extremely small effect on the global environment since it uses solar light as an energy source, and thus the wider distribution of the solar cell is expected.

A variety of studies have been made regarding the principle or materials of the solar cell. Among those solar cells, a solar cell that uses the pn junction of a semiconductor is most widely distributed at the moment, and a number of solar cells that uses silicon as a semiconductor material are on sales. The solar cells are broadly classified into, crystalline silicon-based solar cells that use monocrystalline or polycrystalline silicon, and amorphous silicon-based solar cells that use amorphous silicon.

In any silicon-based solar cell of the crystalline silicon-based solar cell and the amorphous silicon-based solar cell, there were problems in that, since a step for manufacturing a high-purity semiconductor material or a step for forming a pn junction was required, the number of manufacturing steps increased, and, since a manufacturing step under a vacuum was required, the facility cost and the energy cost increased. Therefore, in order to realize a solar cell that can be manufactured at a lower cost, studies have long been made regarding solar cells that use an organic material instead of a silicon-based material, but the majority of the solar cells had a low photoelectric conversion efficiency, and could not be put into practical use.

However, a dye-sensitized solar cell (photoelectric conversion apparatus), to which photoinduced electron transfer was applied, was proposed in 1991(PTL 1). This dye-sensitized solar cell has a high photoelectric conversion efficiency, does not require a large-scale manufacturing apparatus, and can be manufactured readily using a cheap material at a high production efficiency, thus has been expected as a next-generation solar cell.

In PLT 3 co-sensitization of dye-sensitized solar cells is described.

The dye-sensitized solar cell is mainly composed of a transparent substrate such as glass, a transparent electrode (negative electrode) made of a transparent conductive layer such as FTO (fluorine-doped tin oxide (IV) $SnO_2$), a semiconductor layer holding a sensitizing dye, an electrolyte layer, a counter electrode (positive electrode), a counter substrate, a sealing material, and the like.

Citation List

Patent Literature

[PTL1] Japanese Patent Publication No. 2664194
[PTL 2] Japanese Patent Publication No. 4380779
[PLT 3] Japanese patent Publication No. 2007234580

Non-Patent Literature

[NPL 1] Naoyuki Shibayama, et al., 74th Annual Meeting of the Electrochemical Society of Japan (2007), PS06. "Sensitizing dye β - The influence of the fluorine substitution of diketonate terpyridine Ru complex on battery performance"

SUMMARY OF INVENTION

PROBLEMS TO BE SOLVED BY THE INVENTION

In the past, it was considered that, in order to realize a high incident photon-to-current conversion efficiency in a dye-sensitized solar cell, it is preferable to use a single high-purity dye. This is because it is considered that, in a case in which a plurality of dyes are mixed on a semiconductor layer, electron trade or the recombination of electrons and holes occurs between the dyes or electrons moved from an excited dye to the semiconductor layer are trapped by other

dyes such that electrons reaching the transparent electrode from the excited sensitizing dye decrease, and the rate of obtaining a current from absorbed photons, that is, the quantum yield significantly decreases.

As a dye being used solely, a di-tetrabutylammonium cis-bis(isothiocyanato)bis(2,2'-bipyridyl-4.4'-dicarboxylato)ruthenium (II) complex(generally called N719), which is a bipyridine complex, has excellent sensitizing dye performance, and is generally used. Additionally, cis-bis(isothiocyanato)bis(2,2'-bipyridyl-4.4'- dicarboxylic acid)ruthenium (II) complex (generally called N3), which is a bipyridine complex, or tri-tetrabutylammonium tris(isothiocyanato)(2,2':6',2"-terpyridine-4,4',4"-tricarboxylato)ruthenium (II) complex(generally called black dye), which is a kind of terpyridine complexes, are generally used.

Particularly, when N3 or black dye is used, a co-adsorbent is also frequently used. The co-adsorbent is a molecule added to prevent the association of dye molecules on the semiconductor layer, and typical examples of the co-adsorbent include chenodeoxycholic acid, taurodeoxycholate, 1-decrylphosphonic acid, and the like. These molecules have structural characteristics of having a carboxyl group, a phosphono group or the like as a functional group that is readily adsorbed to titanium oxide that configures the semiconductor layer and of forming by a $\sigma$-bond in order to prevent interference between the dye molecules by mediating between dye molecules. In addition, examples in which photosensitizing dyes are used in mixture, also have been reported. However, in this report, a carboxyl group or a phosphono group is used as a fixing group (PTL 2).

Generally, in order to make a solar cell effectively work, first, it is important to increase the optical absorptance so as to take maximum advantage of light incident on the solar cell, and, subsequently, to increase the conversion efficiency at which the absorbed light energy is converted into electric energy. In a dye-sensitized solar cell, since light is absorbed using a photosensitizing dye, an increase of the optical absorptance can be expected by selecting a dye having the optimal optical absorption characteristic with respect to incident light as the sensitizing dye.

Since lights with a variety of wavelengths in series from infrared light to ultraviolet light are included in solar light, in a case in which solar light is applied in a solar cell, it is desirable to select a dye that can absorb lights with as wide a range of wavelengths as possible, including long wavelength ranges, in particular, fully light with a wavelength of 300 nm to 1000 nm, in order to realize a high optical absorptance.

However, the electron states in the photosensitizing dye are quantum-mechanically determined, and only the substance-specific energy states can be obtained. Therefore, the energy difference between an electron at the ground state (HOMO) and an electron at the excited state (LUMO), that is, energy necessary to excite an electron from the ground state to the excited state (band gap energy) is also predetermined as a substance-specific value, and, accordingly, lights that can be absorbed by the sensitizing dye are also limited to lights with specific wavelengths. In addition, it is necessary to prevent the band gap energy of the dye from becoming too small so that an excited electron can be transferred to the conduction band of the semiconductor layer (NPL 1).

For example, it is known that the black dye used as a photosensitizing dye has a wide range of absorption wavelengths with the longest wavelength of approximately 900 nm; however, generally, the molar absorbance coefficient is small, and, particularly, an area with an insufficient absorbance is present on the short wavelength side. N719 has a molar absorbance coefficient that is larger than or equal to that of the black dye on the short wavelength side, but the long wavelength end of the absorption wavelength range is approximately 730 nm, which makes it impossible to effectively use lights with a long wavelength.

As such, at the moment, since there is no dye that can unexceptionally absorb solar light with a wavelength of 300 nm to 1000 nm, in a dye-sensitized solar cell in which a single dye is used, it is difficult to efficiently absorb all the lights with a variety of wavelengths, including solar light. As a result, the optical absorptance is still insufficient.

If a sufficient optical absorption cannot be realized using a single dye, it can be considered to use a mixture of a plurality of dyes having mutually different absorption wavelength characteristics as a photosensitizing dye. However, as described above, when a plurality of dyes are mixed on a single semiconductor layer, in most actual cases, the incident photon-to-current conversion efficiency decreases. This is because the rate of obtaining a current from absorbed photons, that is, quantum yield significantly decreases due to electron transfer or the like between the dyes as described above.

The invention has been made in consideration of the above circumstance, and an object of the invention is to provide a dye-sensitized solar cell having an improved optical absorptance and an improved photoelectric conversion efficiency.

MEANS FOR SOLVING THE PROBLEMS

The invention is a dye-sensitized solar cell including a semiconductor layer holding a photosensitizing dye, an electrolyte layer and a pair of electrodes, wherein the photosensitizing dye includes a dye A having a carboxyl group or a phosphono group as a fixing group with the semiconductor layer, and a dye B having a nitrogen-containing aromatic heterocyclic compound as a fixing group with the semiconductor layer.

The nitrogen-containing aromatic heterocyclic compound may include at least one of a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group.

The fixing group of the dye B may also function as an electron-accepting group.

The dye A may be a polypyridyl complex. At this time, a metal used in the polypyridyl complex may be ruthenium or osmium.

The dye A may be a phthalocyanine complex. At this time, a central metal of the phthalocyanine complex may be any of zinc, iron, tin and copper.

The dye A may include porphyrin.

The dye A may be an organic dye having a carboxyl group as the fixing group. At this time, the carboxyl group may be cyanoacrylate.

In at least any one of the dye A and the dye B, an electron-donating group and the electron-accepting group may be linked directly or through a linking group. At this time, the linking group may be any of N-alkyl carbazole group, 9,9-dialkyl fluorene group, a thiophene group and an oligothiophene group.

In addition, the electron-donating group may be any one of a pyrrole group, an isothianaphthene group, a diphenylamine group, a di(4-alkoxyphenyl)amine group and a carbazole group.

A thickness of the semiconductor layer may be in a range of 0.1 $\mu$m to 50 $\mu$m.

The semiconductor layer may include $TiO_2$. At this time, $TiO_2$ may be anatase $TiO_2$.

The electrolyte layer may be configured of an electrolytic solution, a gel or solid-form electrolyte.

The molecular weight of the dye B is preferably 200 or more.

## Effects of the Invention

It is possible to improve the optical absorptance and the photoelectric conversion efficiency by forming the dye-sensitized solar cell of the invention.

## BRIEF DESCRIPTION OF THE DRAWINGS

FIG. 1 is a schematic cross-sectional view of a dye-sensitized solar cell of the invention.

FIG. 2 is an energy diagram for explaining the working principle of the dye-sensitized solar cell of the invention.

## EMBODIMENTS FOR CARRYING OUT THE INVENTION

A dye-sensitized solar cell in a first embodiment of the invention will be described.

First, a photosensitizing dye used in the dye-sensitized solar cell of the invention will be described. The photosensitizing dye in the dye-sensitized solar cell of the invention is configured to include a sensitizing dye having a carboxyl group or a phosphono group as a functional group (fixing group) that is adsorbed to a semiconductor layer (dye A) and a sensitizing dye having a nitrogen-containing aromatic heterocyclic compound as a fixing group (dye B).

The nitrogen-containing aromatic heterocyclic compound is a cyclic compound that is configured of two or more elements and has aromaticity. The elements include nitrogen. Specific example thereof preferably include a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group. These compounds have imine nitrogen (-C=N-) in the cycle, and thus have an electron-accepting property.

In the dye-sensitized solar cell of the invention, the dye A and the dye B preferably have sufficiently different minimum excitation energies from the ground state (HOMO) to the excited state (LUMO) respectively. At this time, the minimum excitation energies of the plurality of dyes are preferably different by 0.172 eV to 0.209 eV.

In addition, when the effective use of light is taken into account, the dye A and the dye B preferably have the maximum absorption bands in a wavelength range of 400 nm or more after being adsorbed into the semiconductor layer, and more preferably the maximum absorption bands are different in the dye A and the dye B.

In addition, the dye A and the dye B may be preferably made of a dye having a large molar absorbance coefficient and a dye having a small molar absorbance coefficient. At this time, the molar absorbance coefficient of the dye having a large molar absorbance coefficient is preferably 100,000 or more, and the molar absorbance coefficient of the dye having a small molar absorbance coefficient is preferably 100,000 or less.

In addition, the dye A and the dye B are preferably held at mutually different conformations in the semiconductor layer. In the dye-sensitized solar cell of the invention, the photosensitizing dye includes the dye A and the dye B described above. Since the functional groups that are bonded to the semiconductor layer are different in the dye A and the dye B, it is possible to hold the dye A and the dye B at different conformations .

In the dye-sensitized solar cell of the invention, the dye A is preferably a complex dye having a property of causing metal to ligand charge transfer (MLCT), and the dye B is preferably an organic molecular dye having a property of intramolecular charge transfer (CT).

CT refers to charge transfer transition, and MLCT refers to the charge transfer transition from the metal center of the complex dye to a ligand.

As the complex dye having a property of causing MLCT, a polypyridine complex, such as a bipyridine complex, a biquinoline complex or a terpyridine complex, can be used, and for example, black dye or N719, is preferable.

The intramolecular CT refers to charge transfer transition mainly from an electron-donating group to an electron-accepting group in the molecule.

As the organic molecular dye having a property of intramolecular charge transfer (CT), it is possible to use a molecule having both an electron-donating group and an electron-accepting group, and an aromatic conjugated molecule, in which the electron-donating group and the electron-accepting group are linearly disposed directly or through a conjugate system, or the like is preferable. Furthermore, when this molecule is adsorbed to a surface of the semiconductor layer, such as titanium oxide, the molecule desirably has a structure in which the electron-accepting group is disposed on the semiconductor layer side, and the electron-donating group is disposed on the electrolyte layer side, since this structure advantageously works for the transfer of electrons from the dye to the semiconductor layer. This is because the transfer method and transfer direction of charges in the organic molecular dye having a property of CT are different from the transfer method and transfer direction of charges in an inorganic complex dye which causes MLCT.

As the organic molecular dye having a property of intramolecular CT, an aromatic conjugated molecule having any of a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group as the electron-accepting group is used. In the aromatic conjugated molecule, the electron-accepting group is bonded to a Lewis acid group site in the semiconductor layer.

In the dye-sensitized solar cell of the invention, the carboxyl group or the phosphono group of the dye A is bonded with Brønsted acid group sites in the semiconductor layer, and the electron-accepting group of the dye B is bonded to Lewis acid group sites in the semiconductor layer. That is, since the dyes are adsorbed to different sites in the semiconductor layer respectively, the total adsorption amount of the dyes can be increased compared to a case in which a single dye is used solely. Therefore, the photoelectric conversion efficiency improves.

In a case in which only the dye A is used as the photosensitizing dye, only the Brønsted acid group sites in the semiconductor layer is filled by the bonding, the Lewis acid group sites do not bond with the dye, and remains unfilled. Therefore, when the solar cell is manufactured, the Lewis acid group sites are left unfilled, and thus results a decrease in the voltage. In order to prevent the above phenomenon, a method in which 4-tert-butylpyridine (TBP) having a pyridine group is added to the electrolyte so as to suppress a decrease in the voltage and to improve photoelectric conversion efficiency is known.

However, since TBP does not absorb light, in a case in which the Lewis acid group sites are filled using TBP, it is not possible to use light which is supposed to be absorbable using the dye. In the dye-sensitized solar cell of the invention, since the bonding of the dye B to the Lewis acid group sites do not only prevent the above decrease in the voltage but also enables the additional use of photons due to the dye B, the photoelectric conversion efficiency improves.

In addition, since the molecular weight of TBP is small, in a case in which a dye-sensitized solar cell having a Lewis acid group sites filled with TBP is used for a long period of time, there is a problem in that, sometimes, the performance degrades due to the change of properties. From the above viewpoint, the dye B bonded to the Lewis acid group sites have a molecular weight of preferably 200 or more, and more preferably 300 or more. In addition, the dye B still more preferably has an electron-accepting group (refer to Chem. 8) described below.

In addition, TBP is a liquid in an environment of room temperature to 100°C at which the dye-sensitized solar cell works. Therefore, when the dye-sensitized solar cell, in which TBP is used, is used in a high-temperature environment, there is a problem in that TBP is likely to dissociate from the Lewis acid group sites, and dissociation degrades the solar cell performance. From the above viewpoint, when a dye that maintains a solid state is used as the dye B in an environment of room temperature to 100°C, the dye B does not readily dissociate from the Lewis acid group sites, which is preferable.

In the aromatic conjugated molecule which is used as the dye B, the electron-donating group is not particularly limited, but preferably has a higher electron-donating property than the fixing group of the dye B, and preferably has any of a pyrrole group, an isothianaphthene group, a diphenylamine group, a di(4-alkoxyphenyl)amine group and a carbazole group.

The dye B bonds the nitrogen-containing aromatic heterocyclic compound, such as a pyridine group, a pyridazine group, a pyrimidine group, 1,3,5-triazine group, an imidazole group, a pyrazole group, a thiazole group, a thiadiazole group, a triazole group, 1,8-naphthyridine group or a purine group, to the semiconductor layer as the fixing group, and is bonded to the semiconductor layer in a different steric configuration from that of the dye A. Therefore, the dye A and the dye B can coexist on the surface of the semiconductor layer without strong interaction between them even when being adjacent to each other, and do not mutually impair the photoelectric conversion performance thereof. In addition,

the dyes taking different steric configuration as described above effectively interpose between the sensitizing dyes bonded to the surface of the semiconductor layer, and at least one of the dye A and the dye B suppresses association, thereby preventing useless electron transfer between the dyes. Therefore, excited electrons are efficiently transferred to the semiconductor layer from a different dye that has absorbed light without a useless electron transfer between the dyes, and therefore the photoelectric conversion efficiency improves.

Since at least one or more dyes of the dye A having a carboxyl group or a phosphono group as the fixing group and the dye B having the nitrogen-containing aromatic heterocyclic compound, such as a pyridine group, a pyridazine group, a pyrimidine group, 1,3,5-triazine group, an imidazole group, a pyrazole group, a thiazole group, a thiadiazole group, a triazole group, 1,8-naphthyridine group or a purine group suppress association, when the dyes are used in a mixture form, it is possible to improve the photoelectric conversion efficiency compared to when one of the dye A and the dye B is used solely.

In addition, the aromatic conjugated molecule may introduce a conjugated linking group, such as N-alkyl carbazole group, 9,9-dialkylfluorene group, a thiophene group or an oligothiophene group, as a linking group between the electron-accepting group and the electron-donating group. When these linking groups having a conjugated system are used, it is possible to adjust the wavelength range of absorbable light.

FIG. 1 illustrated a schematic cross-sectional view of the dye-sensitized solar cell of the embodiment. A dye-sensitized solar cell 10 of the embodiment is configured of a transparent electrode (negative electrode) 2, a semiconductor layer 3 holding a plurality of sensitizing dyes, an electrolyte layer 5, an counter electrode (positive electrode) 6 and an counter substrate 7 sequentially from a transparent substrate 1 side. Meanwhile, in FIG. 1, the transparent substrate 1 and the transparent electrode 2 are used as a negative electrode, and light is made to enter from a negative electrode 2 side, but the dye-sensitized solar cell of the invention is not limited to the configuration of FIG. 1, and light may be made to enter from a positive electrode side by using a transparent material for the electrode and the substrate on the positive electrode side. In addition, it is also possible to make light enter from both positive and negative electrode sides by using a transparent material for the electrodes and the substrates on both positive and negative electrodes.

As the semiconductor layer 3, for example, a porous layer obtained by sintering fine particles of titanium oxide $TiO_2$ can be used. A plurality of sensitizing dyes including one or more kinds of each of the dye A and the dye B are held on the surfaces of the fine particles that configure the semiconductor layer 3. The electrolyte layer 5 is loaded between the semiconductor layer 3 and the counter electrode 6, and an organic electrolytic solution including redox species (redox couple), such as $I^-/I_3^-$, or the like is used for the electrolyte layer. The counter electrode 6 is configured of, for example, a platinum layer or the like, and is formed on the counter substrate 7.

The dye-sensitized solar cell 10 has no structural difference from a dye-sensitized solar cell of the related art except that the sensitizing dye includes one or more kinds of each of the dye A having a carboxyl group or a phosphono group and the dye B having a nitrogen-containing aromatic heterocyclic compound, such as a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group.

FIG. 2 illustrated an energy diagram for explaining the working principle of the dye-sensitized solar cell of the invention. When light enters, the dye-sensitized solar cell 10 works as the solar cell using the counter electrode 6 as a positive electrode and the transparent electrode 2 as a negative electrode. The principle is as follows. (Meanwhile, in FIG. 2, it is assumed that FTO is used as the material of the transparent electrode 2, titanium oxide $TiO_2$ is used as the material of the semiconductor layer 3, and a redox species of $I^-/I_3^-$ is used as a redox couple.)

When the sensitizing dye absorbs photons that have permeated the transparent substrate 1, the transparent electrode 2 and the semiconductor layer 3, electrons in the sensitizing dye are excited from the ground state (HOMO) to the excited state (LUMO). At this time, in the dye-sensitized solar cell 10, since the sensitizing dye includes the dye A and the dye B, lights with a broader range of wavelengths can be absorbed at a high optical absorptance compared to a dye-sensitized solar cell of the related art, in which the sensitizing dye is made of a single dye.

The electrons in the excited state are extracted into the conduction band of the semiconductor layer 3 through an electric bond between the sensitizing dye and the semiconductor layer 3, and reach the transparent electrode 2 through the semiconductor layer 3. At this time, since the dye A and the dye B included in the sensitizing dye are bonded to the semiconductor layer 3 at different bond sites, both dyes do not mutually decrease the quantum yields thereof, the photon-to-current conversion efficiency of the plurality of dyes develops, and the generation amount of a current significantly improves.

In addition, in a case in which only plural kinds of the dye A are used, only the Brønsted acid group sites are filled in the semiconductor layer; however, when the dye B is used at the same time, the transfer of electrons from the Lewis acid group sites to the electrolyte layer 5 is prevented, and a current value and a voltage value can be improved through the optical absorption of the dye A and the dye B.

During a measurement of a current-voltage curve, when the voltage value is gradually increased, the Fermi level of the semiconductor layer is shifted toward the LUMO side of the sensitizing dye, and the Fermi level of the semiconductor layer and the LUMO level of the sensitizing dye approximate to each other such that electrons are

transferred from the semiconductor layer to the electrolyte layer, and thus the current value gradually decreases. This is because it becomes easy for electron transfer from the semiconductor layer 3 to the electrolyte layer 5 to occur, and the transfer of electrons from the semiconductor layer 3 to the electrolyte layer 5 can be prevented by filling both the Brønsted acid group sites and the Lewis acid group sites in the semiconductor layer with the sensitizing dye. Thereby, the voltage value and the fill factor can be improved.

Meanwhile, the sensitizing dye that has lost electrons receives electrons from a reducing agent, for example, $I^-$ in the electrolyte layer 5 through the following reaction, and generates an oxidizing agent, for example, $I^{3-}$ (a combined body of $I_2$ an $I^-$) in the electrolyte layer 5.

$$2I^- \rightarrow I_2 + 2e^-$$

$$I_2 + I^- \rightarrow I^{3-}$$

The generated oxidizing agent reaches the counter electrode 6 through diffusion, receives electrons from the counter electrode 6 through the reverse reaction of the above reaction, described below, and returns to the original reducing agent.

$$I^{3-} \rightarrow I_2 + I^-$$

$$I_2 + 2e^- \rightarrow 2I^-$$

Electrons sent out from the transparent electrode 2 to an external circuit do electric works in the external circuit, and then return to the counter electrode 6. Thereby, light energy is converted into electric energy without remaining change in both the sensitizing dye and the electrolyte layer 5.

As the dye A that configures the sensitizing dye, an aromatic conjugated molecule having a carboxyl group -COOH or a phosphono group $-PO(OH)_2$ is used. The carboxyl group or the phosphono group bonds to the Brønsted acid group site in the semiconductor layer by producing an ester bond. The aromatic conjugated molecule preferably has a carboxyl group, and more preferably has a polypyridine complex having a carboxyl group. As the polypyridine complex, a bipyridine complex, a biquinoline complex or a terpyridine complex can be used. Specifically, a di-tetrabutylammonium cis-bis(isothiocyanato)bis(2,2'-bipyridyl-4.4'- dicarboxylato)ruthenium (II) complex, which is a bipyridine complex, (N719) has excellent sensitizing dye performance, and is generally used. Additionally, a cis-bis(isothiocyanato)bis(2,2'-bipyridyl-4.4'-dicarboxylato)ruthenium (II)complex, which is a bipyridine complex, (generally called N3) or a tri-tetrabutylammonium tris(isothiocyanato)(2,2':6',2"-terpyridine-4,4',4"-tricarboxylato)ruthenium (II) complex, which is a terpyridine complex, (black dye) can be used.

[Chem. 1] illustrates the structural formula of the di-tetrabutylammonium cis-bis(isothiocyanato)bis(2,2'-bipyridyl-4.4'-dicarboxylato)ruthenium (II) complex (N719) which is used as the polypyridine complex.

[Chem. 1]

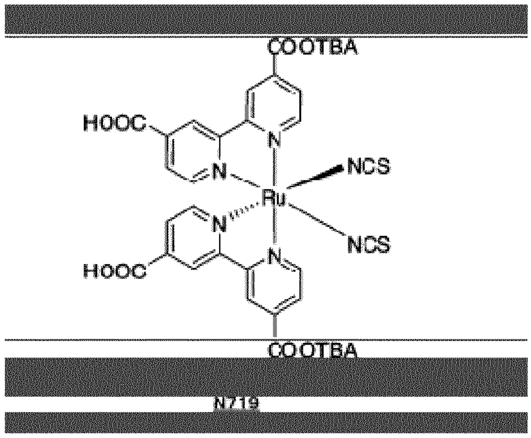

N719

[Chem. 2] illustrates the structural formula of the tri-tetrabutylammonium tris(isothiocyanato)(2,2':6',2"-terpyridine-4,4',4"-tricarboxylato)ruthenium (II) complex (black dye) which is used as the polypyridine complex.

[Chem. 2]

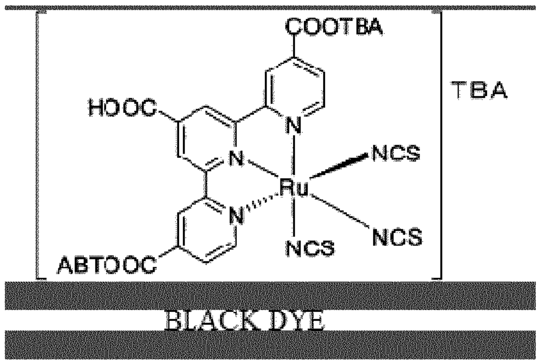

BLACK DYE

The carboxyl group -COOH or the phosphono group $-PO(OH)_2$ of the dye A also functions as an electron-accepting group. Among the carboxyl groups, cyanoacrylate is most preferable in consideration of the energy level. In addition, the dye A preferably has any of a pyrrole group, an isothianaphthene group, a diphenylamine group, a di(4-alkoxyphenyl)amine group and a carbazole group as a functional group as the electron-donating group. [Chem. 3] illustrates examples of the electron-donating group in the dye A, but the electron-donating group is not limited thereto. Meanwhile, to the portions represented by R in [Chem. 3], hydrogen or a compound represented by $C_nH_{2n+1}$ (herein, n = 1 to 16) may be bonded.

[Chem. 3]

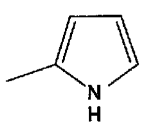 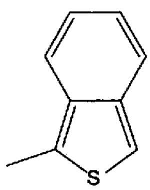 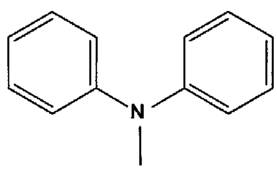

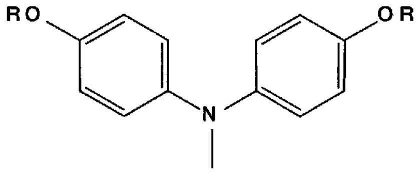

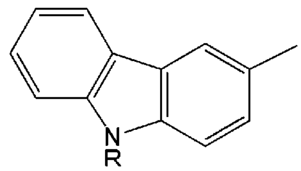

In addition, the dye A may introduce a conjugated linking group, such as N-alkyl carbazole group, 9,9-dialkylfluorene group, a thiophene group or an oligothiophene group, as a linking group between the electron-accepting group and the electron-donating group. Meanwhile, the linking group in the invention refers to a divalent organic group that links the electron-accepting group and the electron-donating group. Among the above conjugated linking groups, the thiophene group is preferable since the thiophene group has highly stable electrons, and can be stereocontrolled by appropriately selecting a substituent of the side chain.

[Chem. 4] illustrates examples of the linking group of the dye A. In (a) and (b) of Chem. 4, to the portions represented by R1 to R15, hydrogen or a compound represented by $C_nH_{2n+1}$ (herein, n = 1 to 16) or $OC_nH_{2n+1}$ (herein, n = 1 to 16) may be bonded. Here, in the case of the thiophene group illustrated in (c) of Chem. 4, it is preferable that a be any of 1, 2 and 0, n be in a range of 1 to 10, $R_x$ be hydrogen or a compound represented by $C_nH_{2n+1}$ (herein, n = 1 to 16), and the thiophene group be linked at the 2- or 5-position. In addition, a different substance may be linked to each of the repetitive structures.

Meanwhile, the electron-accepting group and the electron-donating group may be directly linked without interposing a linking group therebetween.

[Chem. 4]

(a)

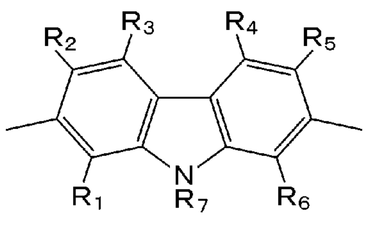

(b)

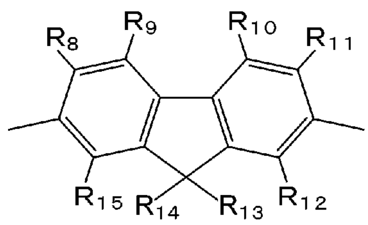

(c)

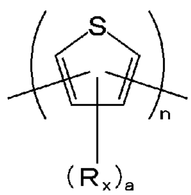

In addition, as the dye A, an organic dye, for example, MK-2, can be used as well as the above aromatic conjugated molecules. [Chem. 5] illustrates the structural formula of MK-2.

[Chem. 5]

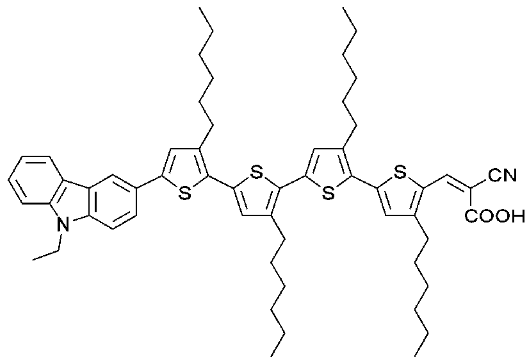

Furthermore, as the dye A, it is also possible to use a phthalocyanine complex illustrated in [Chem. 6]. Meanwhile, in Chem. 6, M represents a metal selected from a group consisting of Zn, Cu, Mg, Ni, Fe, Mn, Co, Ru, Os and Ir, and has one or more substituents including a carboxyl group at any of R1 to R4. The phthalocyanine complex is excellent since the complex is not readily deteriorated or decomposed by light, and has a high stability with respect to light. In addition, the phthalocyanine complex also has an advantage of a relatively broad range of wavelengths at which light is absorbable.

[Chem. 6]

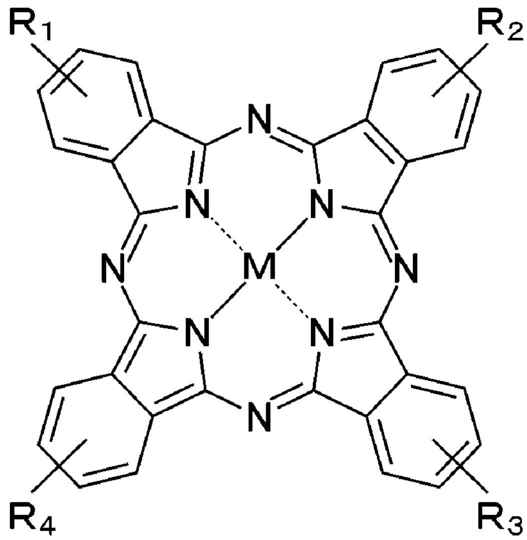

Furthermore, it is also possible to use a dye including porphyrin, illustrated in [Chem. 7], as the dye A. The porphyrin complex is excellent since the complex is not readily deteriorated or decomposed by light, and has a high stability with respect to light. In addition, the porphyrin complex also has an advantage of a relatively broad range of wavelengths at which light is absorbable. Meanwhile, in Chem. 7, the portions represented by M and R1 to R4 are the same as in Chem. 6.

[Chem. 7]

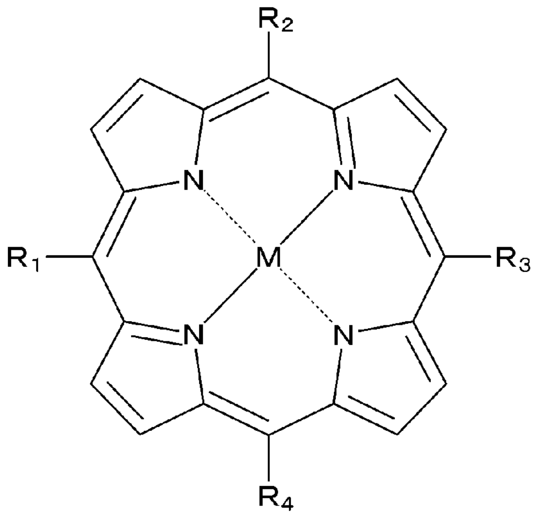

In addition, the Lewis acid group site in the semiconductor layer bonds to the dye B made of an aromatic conjugated molecule having a functional group including a lone pair. The dye B has a nitrogen-containing aromatic heterocyclic compound, such as a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group as the electron-accepting group. [Chem. 8] illustrates examples of the electron-accepting group of the dye B. Among the above, an aromatic conjugated molecule having a pyridine group is particularly preferably used as the dye B from the viewpoint of conformation when bonding with the Lewis acid group site in the semiconductor layer.

[Chem. 8]

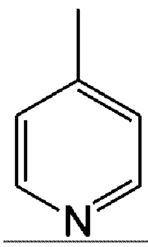
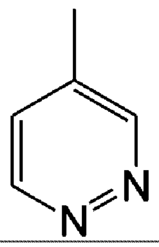
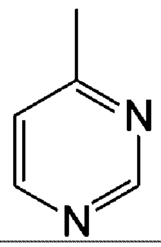
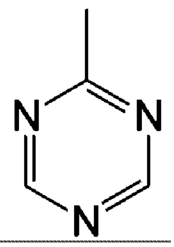

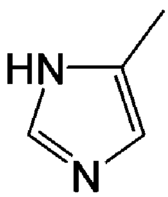
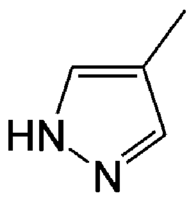
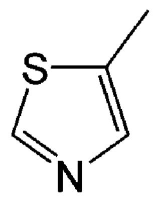
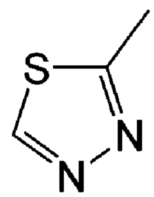

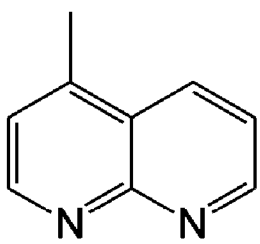
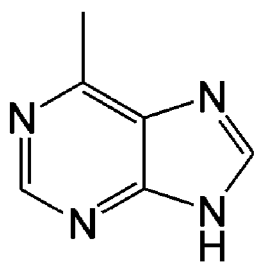

In addition, the dye B preferably has any of a pyrrole group, an isothianaphthene group, a diphenylamine group,

a di(4-alkoxyphenyl)amine group and a carbazole group as the electron-donating group. [Chem. 9] illustrates examples of the electron-donating group of the dye B; however, similarly to the dye A, the electron-donating group is not limited thereto.

To the portions represented by R in [Chem. 9], hydrogen or a compound represented by $C_nH_{2n+1}$ (herein, n = 1 to 16) may be bonded.

[Chem. 9]

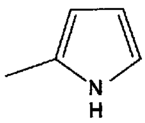

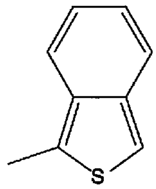

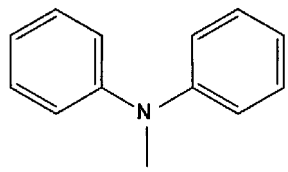

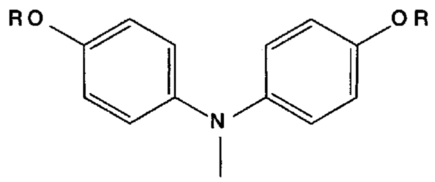

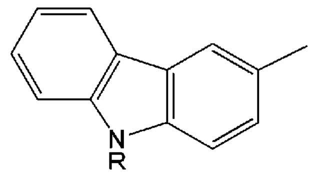

In addition, the dye B may introduce a conjugated linking group, such as N-alkyl carbazole group, 9,9-dialkylfluorene group, a thiophene group or an oligothiophene group, as a linking group between the electron-accepting group and the electron-donating group. [Chem. 10] illustrates examples of the linking group of the dye B. Even for the dye B, similarly to the dye A, a thiophene group is preferable as the linking group, and the electron-accepting group and the electron-donating group may be directly linked. In addition, the description in Chem. 10 is the same as in Chem. 4.

[Chem. 10]

(a) (b)

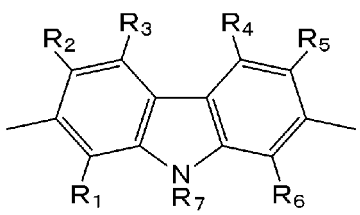

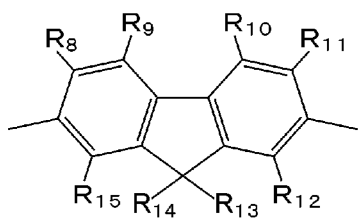

(c)

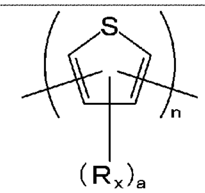

As the aromatic conjugated molecule having a pyridine group, which is a preferable example of the dye B, it is

possible to use, for example, 4-[5'-(N,N-di-4-methoxyphenyl)amino-3',4-di-n-hexyl-[2,2',5']-bithiophen-5-yl]pyridin e. [Chem. 11] illustrates the structural formula of the dye.

[Chem. 11]

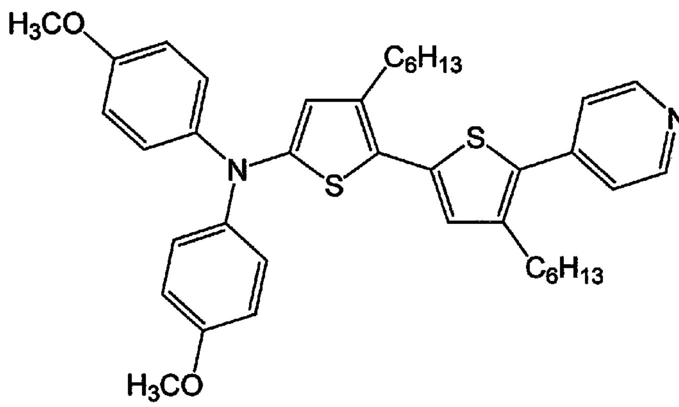

It has been already described that, in the dye-sensitized solar cell, the optical absorptance and the photoelectric conversion efficiency are not necessarily improved simply by using a plurality of sensitizing dyes; however, as a result of repetitive studies regarding the combinations of a variety of dyes, the present inventors found a combination of dyes that can improve the optical absorptance and the photoelectric conversion efficiency. That is, the inventors found that, in a case in which the dye A having a small molar absorbance coefficient but a broad absorption wavelength range, such as black dye, N719 or MK-2 which has a carboxyl group or a phosphono group and bonds to the Brønsted acid sites in the semiconductor layer, (hereinafter sometimes referred to as basic dye) and the dye B having a large molar absorbance coefficient but a narrow absorption wavelength range, which has a nitrogen-containing aromatic heterocyclic compound, such as a pyridine group, a pyridazine group, a pyrimidine group, 1,3,5-triazine group, an imidazole group, a pyrazole group, a thiazole group, a thiadiazole group, a triazole group 1,8-naphthyridine group and a purine group and bonds to the Lewis acid sites in the semiconductor layer, (hereinafter sometimes referred to as auxiliary dye) are combined, the photoelectric conversion efficiency improves, and achieved the invention.

According to the incident photon-to-current conversion efficiency (IPCE) spectrum of a combination of the black dye and the dye B, which is an example of the invention, a relationship is found in which the absorption of light in a short wavelength range, in which the absorbance of the black dye, which is the basic dye, is insufficient, is supplemented by the dye B, which is the auxiliary dye. Furthermore, while the black dye has the absorption peak wavelength in a wavelength range of 400 nm or more, and the long wavelength end of the absorption wavelength range at approximately 860 nm, the dye B has the absorption peak wavelength in a wavelength range of 400 nm or less, and the long wavelength end of the absorption wavelength range at approximately 480 nm. This indicates that the band gap energies of both dyes are significantly different. The reason for no decrease in the photoelectric conversion efficiency in a case in which the black dye and the dye B are mixed on the semiconductor layer 3, unlike known examples of the related art, is considered to be that, since the band gap energies of both dyes are significantly different, electron transfer does not easily occur between the dyes. In addition, it is considered to be because the dyes are attached to the semiconductor layer at different sites, and have conformations in which electron transfer between the dyes does not easily occur. The dye B serves as a sensitizing dye having a large absorbance in a short wavelength range.

The energy view of FIG. 2 illustrates a mechanism in which the photoelectric conversion efficiency of the dye B improves in a system having a sensitizing dye made up of the dye A and the dye B. As described above, when the respective dyes absorb photons respectively, electrons in the dyes are excited from the ground state (HOMO) to the excited state (LUMO). In this system, there are two paths through which electrons of the dye B in the excited state are extracted to the conduction band of the semiconductor layer 3. That is, there are a direct path, through which electrons are directly extracted to the conduction band of the semiconductor layer 3 from the excited state of the dye B, and an indirect path, through which the electrons of the dye B in the excited state are, first, extracted to the excited state of the dye A having a low energy level, and then extracted from the excited state of the dye A to the conduction band of the semiconductor layer 3. Due to the contribution of the indirect path 12, the photoelectric conversion efficiency of the dye B improves in a system in which the dye A coexists.

In a system in which the dye A and the dye B coexist, the photoelectric conversion efficiency improves. It is known that, in the black dye, the flatness of a terpyridine group is high, and, when there is no association inhibitor (co-adsorbent), electron transfer occurs between the black dyes, and the efficiency decreases. That is, the fact that the photoelectric conversion efficiency is improved by using the dye B in conjunction with the black dye without using an association inhibitor in the example indicates that the dye B functions as an association inhibitor. However, this effect does not defy the joint use of other association inhibitors, and other association inhibitors may be jointly used.

The method for holding the sensitizing dye in the semiconductor layer is not particularly limited, but it is preferable that the sensitizing dye be dissolved in an appropriate solvent, for example, an alcohol, a nitrile, nitromethane, halogenated hydrocarbon, an ether, dimethyl sulfoxide, an amide, N-methylpyrrolidone, 1,3-dimethylimidazolidinone, 3-methyloxazolinone, an ester, a carbonate ester, a ketone, hydrocarbon, THF or water; and the semiconductor layer 3 be immersed in the dye solution, or the dye solution be coated on the semiconductor layer 3, whereby a photosensitizing dye be adsorbed to the semiconductor layer 3. In addition, in order to reduce the association between the dyes, deoxycholic acid, which is supposed to suppress the association between the dyes, may be added to the dye solution.

In addition, in the dye-sensitized solar cell of the invention, in order to reduce the association between the photosensitizing dyes, a co-adsorbent may be added to the photosensitizing dye solution. As the co-adsorbent, for example, chenodeoxycholic acid, a taurodeoxycholate salt, 1-decryl phosphonic acid, or the like can be used; however, generally, chenodeoxycholic acid is used. The concentration is generally 10 $\mu$mol/L (M) to 0.5 M, and particularly preferably 0.3 $\mu$M to 0.2 M.

In order to remove excessively adsorbed dyes, the surface of the semiconductor layer 3 may be treated using an amine after the dyes are adsorbed. Examples of the amine include pyridine, 4-tert-butylpyridine, polyvinylpyridine, and the like. These amines may be used as they are in a case in which the amines are liquid, and may be dissolved in an organic solvent and then used.

Members other than the sensitizing dye are the same as those in the dye-sensitized solar cell or the like of the related art, but will be hereinafter described in detail.

The transparent substrate 1 is not particularly limited as long as the material and shape allow easy permeation of light, and a variety of substrate materials can be used, but a substrate material having a high transmittance of visible light is particularly preferable. In addition, a material which has a high interrupting performance that inhibits moisture or gas, which is likely to intrude into the photoelectric conversion element from outside, and is excellent in terms of solvent resistance or weather resistance is preferable. Specific examples thereof include transparent inorganic substrates, such as silica or glass, and transparent plastic substrates, such as polyethylene terephthalate, polyethylene naphthalate, polycarbonate, polystyrene, polyethylene, polypropylene, polyphenylene sulfide, polyvinylidene fluoride, acetyl cellulose, brominated phenoxy, aramids, polyimides, polystyrenes, polyacrylates, polysulfones, and polyolefins. The thickness of the transparent substrate 1 is not particularly limited, and can be appropriately selected in consideration of the transmittance of light and a performance that interrupts the inside and outside of the photoelectric conversion element.

On the surface of the transparent substrate 1, the transparent electrode (transparent conductive layer) 2 is formed as an electron-extracting electrode (negative electrode). The surface resistivity of the transparent conductive layer 2 is preferably smaller, and, specifically, is preferably 500 Ω/sq. (Ω/) or less, and more preferably 100 Ω/□ or less. A well-known material can be used as the material that forms the transparent conductive layer 2, and examples thereof include indium-tin composite oxide (ITO), fluorine-doped tin (IV) oxide $SnO_2$ (FTO), tin (IV) oxide $SnO_2$, zinc (II) oxide ZnO, indium-zinc composite oxide (IZO) and the like. In addition, the material is not limited thereto, and two or more materials can be combined for use. The transparent conductive layer 2 is formed using a sputtering method or the like.

The surface resistivity was measured using a Loresta-GP MCP-T610 manufactured by Mitsubishi Chemical Analytech Co., Ltd. This device is based on JIS K7194-1994. The unit is expressed by Ω/sq. or Ω/□, but is substantially Ω (sq. and □ are dimensionless).

In addition, the surface resistivity refers to a numeric value obtained by dividing the electrical gradient in a direction parallel to a current flowing along the surface of a test specimen by a current per unit width of the surface. This numeric value is defined in JIS K6911-1995 to be equal to the surface resistance between two electrodes which correspond to the facing sides of a 1 cm × 1 cm square.

In addition, for the purpose of reducing the resistance of the electron extraction path and improving the efficiency, it is also possible to form a highly conductive metal wire using patterning. The material of the metal wire is not particularly limited, but the metal material desirably has high corrosion resistance, high oxidation resistance and the metal material itself desirably has low leakage current. In addition, a material having a low corrosion resistance can still be used by providing a separate protective layer. In addition, for the purpose of reducing the dark current from the substrate, it is also possible to provide a variety of oxide thin film barrier layers to the metal wire.

As the semiconductor layer 3, a porous film obtained by sintering fine semiconductor particles is frequently used. As a semiconductor material, in addition to a single semiconductor material represented by silicon, a compound semiconductor material, a material having a perovskite structure or the like can be used. The semiconductor material is preferably an n-type semiconductor material, in which conduction band electrons serve as carriers under photoexcitation and an anode current is generated. Specific examples include titanium oxide $TiO_2$, zinc oxide ZnO, tungsten oxide $WO_3$, niobium oxide $Nb_2O_5$, strontium titanate $SrTiO_3$ and tin oxide $SnO_2$, and anatase-type titanium oxide $TiO_2$ is

particularly preferable. In addition, the kind of the semiconductor material is not limited thereto, and the semiconductor material can be used solely, or two or more semiconductor materials can be mixed or composited for use. In addition, the fine semiconductor particles can have a variety of forms, such as a grain form, a tubular form and a rod form, as necessary.

The method for forming the semiconductor layer 3 is not particularly limited, in a case in which properties, convenience, manufacturing costs and the like are taken into account, a wet film-forming method is preferable, and a method, in which a paste-form dispersion fluid is prepared by uniformly dispersing the powder or sol of fine semiconductor particles in a solvent, such as water, and the dispersion fluid is coated or printed on the transparent substrate 1 having the transparent conductive layer 2 formed thereon, is preferable. The coating method or the printing method is not particularly limited, and can be carried out according to a well-known method. For example, as the coating method, the dip method, the spray method, the wire bar method, the spin coat method, the roller coat method, the blade coat method, the gravure coat method or the like can be used, and, as the wet printing method, the relief printing method, the offset printing method, the gravure printing method, the intaglio printing method, the rubber printing method, the screen printing method or the like can be used.

The crystal type of titanium oxide is preferably an anatase type that is excellent in terms of photocatalytic activity. As the anatase-type titanium oxide, commercially available powder-form, sol-form or slurry-form titanium oxide may be used, or titanium oxide having a predetermined particle diameter may be formed using a well-known method, such as the hydrolysis of titanium oxide alkoxide. When commercially available powder is used, it is preferable to remove the secondary agglomeration of particles, and, when the paste-form dispersion fluid is prepared, it is preferable to crush particles using a mortar, a ball mill or the like. At this time, in order to prevent the re-agglomeration of the particles, for which the secondary agglomeration has been removed, acetyl acetone, hydrochloric acid, nitric acid, a surfactant, a chelating agent or the like can be added to the paste-form dispersion fluid. In addition, in order to increase the viscosity of the paste-form dispersion fluid, it is also possible to add macromolecules, such as polyethylene oxide or polyvinyl alcohol, or a variety of viscosity improvers, such as a cellulose-based viscosity improver, to the paste-form dispersion fluid.

The particle diameter of the fine semiconductor particles is not particularly limited, the average particle diameter of the primary particles is preferably 1 nm to 200 nm, and particularly preferably 5 nm to 100 nm. In addition, it is also possible to mix particles having a larger size than the fine semiconductor particles and scatter incident light, thereby improving the quantum yield. In this case, the average size of the separately mixed particles is preferably 20 nm to 500 nm.

The semiconductor layer 3 preferably has a large effective surface area, which includes the fine particle surfaces facing holes in the porous film, so that many sensitizing dyes can be adsorbed. Therefore, the effective surface area in a state in which the semiconductor layer 3 is formed on the transparent electrode 2 is preferably 10 times or more, and more preferably 100 times or more than the area of the outside surfaces (projected area) of the semiconductor layer 3. This ratio is not particularly limited, but is, in general, approximately 1000 times.

Meanwhile, the average particle diameter was computed by measuring the particle diameters using SEM photographs. Hereinafter, in the present application, the average particle diameter was computed using the same method.

Generally, as the thickness of the semiconductor layer 3 increases, and the number of the fine semiconductor particles included per unit projected area increases, the effective surface area increases, and the amount of the dye that can be held per unit projected area increases, and therefore the optical absorptance increases. On the other hand, when the thickness of the semiconductor layer 3 increases, the distance, which the electrons transferred to the semiconductor layer 3 from the sensitizing dye diffuse to reach the transparent electrode 2, increases, and therefore electron loss due to charge recombination in the semiconductor layer 3 also increases. Therefore, there is a preferable thickness of the semiconductor layer 3, and the thickness is generally 0.1 $\mu$m to 100 $\mu$m, more preferably 1 $\mu$m to 50 $\mu$m, and particularly preferably 3 $\mu$m to 30 $\mu$m.

After the fine semiconductor particles are coated or printed on the transparent electrode 2, the semiconductor layer 3 is preferably sintered in order to electrically connect the fine particles and improve the mechanical strength of the semiconductor layer 3, thereby improving the adhesiveness with the transparent electrode 2. The range of the sintering temperature is not particularly limited; however, when the temperature is excessively increased, the electric resistance (surface resistivity) of the transparent electrode 2 increases, and, furthermore, there are cases in which the transparent electrode 2 is melted, and therefore, in general, the temperature range is preferably 40°C to 700°C, and more preferably 40°C to 650°C. In addition, the sintering time is not particularly limited, but is generally approximately 10 minutes to 10 hours.

After the sintering, for the purpose of increasing the surface area of the fine semiconductor particles or increasing necking between the fine semiconductor particles, for example, a dip treatment may be carried out using titanium tetrachloride aqueous solution or a sol of ultrafine titanium oxide particles having a diameter of 10 nm or less. In a case in which a plastic substrate is used as the transparent substrate 1 that holds the transparent electrode (transparent conductive layer) 2, it is also possible to form the semiconductor layer 3 on the transparent conductive layer 2 using the paste-form dispersion fluid including a binding agent, and pressure-bond the semiconductor layer to the transparent conductive layer 2 using a hot press.

As the electrolyte layer 5, an electrolytic solution or a gel-form or solid-form electrolyte can be used. Examples of the electrolytic solution include solutions including a redox system (redox couple), and, specifically, a combination of iodine $I_2$ and an iodide salt of a metal or an organic substance or a combination of bromine $Br_2$ and a bromide salt of a metal or an organic substance is used. Examples of the cation that configures the metal salt include lithium $Li^+$, sodium $Na^+$, potassium $K^+$, cesium $Cs^+$, magnesium $Mg^{2+}$, calcium $Ca^{2+}$ and the like, and the cation that configures the organic substance salt is preferably a quaternary ammonium ion, such as a tetraalkyl ammonium ion, a pyridinium ion or an imidazolium ion, but is not limited thereto, and the cation can be used solely, or two or more cations can be used in a mixture form.

In addition to the above, as the electrolyte, it is possible to use a metal complex, such as a combination of ferrocyanate and ferricyanate or a combination of ferrocene and a ferricinium ion, a cobalt complex, a sulfur compound, such as sodium polysulfide or a combination of alkyl thiol and alkyl disulfide, a viologen dye or a combination of hydroquinone and quinone.

Among the above, an electrolyte obtained by combining iodine $I_2$ and lithium iodide LiI, sodium iodide NaI or a quaternary ammonium compound, such as imidazolium iodide, is particularly preferable. The concentration of the electrolyte salt is preferably 0.05 M to 10 M, and more preferably 0.2 M to 3 M with respect to the solvent. The concentration of iodine $I_2$ or bromine $Br_2$ is preferably 0.0005 M to 1 M, and more preferably 0.001 M to 0.5 M. In addition, for the purpose of improving the open voltage or short-circuit current, it is also possible to add a variety of additives, such as 4-tert-butylpyridine or benzimidazoliums.

In a case in which a cobalt complex is used as the electrolyte instead of iodine, compared to a case in which iodine is used, since it becomes difficult for the corrosion of metal to occur, use of metal wires and the like in the dye-sensitized solar cell becomes possible.

Examples of the solvent that configures the electrolytic solution include water, alcohols, ethers, esters, carbonate esters, lactones, carboxylate esters, phosphate triesters, heterocyclic compounds, nitriles, ketones, amides, nitromethane, halogenated hydrocarbon, dimethyl sulfoxide, sulfolane, N-methylpyrrolidone, 1,3-dimethylimidazolidinone, 3-methyloxazolidinone, hydrocarbon and the like, but the solvent is not limited thereto, and can be used solely, or two or more solvents can be used in a mixture form. In addition, it is also possible to use a room temperature ionic liquid of a tetraalkyl-based, pyridinium-based or imidazolium-based quaternary ammonium salts as the solvent. In addition, in order to prevent the leakage of the electrolyte, a solid metal salt represented by $CuI_2$ or the like may be used.

For the purpose of reducing the leakage of the electrolytic solution from the dye-sensitized solar cell 10 or the evaporation of the solvent that configures the electrolytic solution, it is also possible to mix a gelling agent, a polymer, a crosslinking monomer or the like with the constituents of the electrolyte through dissolution or dispersion, and to use the mixture as a gel-form electrolyte. Regarding the ratio between a gelling material and the constituents of the electrolyte, as the constituents of the electrolyte increases, the ion conductivity increases, but the mechanical strength decreases. Conversely, when the constituents of the electrolyte are too little, the mechanical strength is large, but the ion conductivity decreases. Therefore, the constituents of the electrolyte is preferably 50 wt% to 99 wt%, and more preferably 80 wt% to 97 wt% of the gel-form electrolyte. In addition, it is also possible to realize an all-solid-state dye-sensitized solar cell by removing a plasticizer through volatilization after mixing the electrolyte and the plasticizer, and the polymer.

As the material of the counter electrode 6, an arbitrary material can be used as long as the material is a conductive substance, but any material can be used as long as a conductive layer is formed on a side of an insulating material, which faces the electrolyte layer 5. However, an electrochemically stable material is preferably used as the material of the counter electrode 6, and, specifically, platinum, gold, carbon, a conductive polymer or the like is desirably used.

In addition, in order to improve the catalytic action with respect to a reduction reaction in the counter electrode 6, a fine structure is preferably formed on a surface of the counter electrode 6, which is in contact with the electrolyte layer 5, so as to increase the effective surface area, and, for example, when the fine structure is formed of platinum, the platinum is preferably formed in a platinum black state, and, when the fine structure is formed of carbon, the carbon is preferably formed in a porous carbon state. The platinum black can be formed using the anodization method of platinum, a chloroplatinic acid treatment or the like, and the porous carbon can be formed using a method, such as sintering of fine carbon particles, firing of an organic polymer, or the like.

Since the counter substrate 7 does not need to transmit light, an opaque glass plate, an opaque plastic plate, an opaque ceramic plate and an opaque metal plate can be used as the material of the counter substrate. In addition, it is also possible to form a transparent conductive layer on a transparent counter electrode, and form a wire using a metal having a strong redox catalysis, such as platinum, on the transparent conductive layer, or to carry out a chloroplatinic acid treatment on the surface, thereby using the product as the transparent counter electrode 7.

The method for manufacturing the dye-sensitized solar cell 10 is not particularly limited. In a case in which the electrolyte is a liquid or in another case in which a liquid-form electrolyte is introduced and made to gelate in the dye-sensitized solar cell 10, a method in which an electrolytic solution is injected into the dye-sensitized solar cell 10 having a previously-sealed periphery and an injection opening provided thereto.

In order to seal the dye-sensitized solar cell 10, the semiconductor layer 3 and the counter electrode 6 are disposed opposing each other with an appropriate gap therebetween so that the semiconductor layer and the counter electrode do not come into contact with each other, and the substrate 1 and the counter substrate 7 are attached in a region in which the semiconductor layer 3 is not formed. The size of the gap between the semiconductor layer 3 and the counter electrode 6 is not particularly limited, but is generally 1 μm to 100 μm, and more preferably 1 μm to 50 μm. When the distance of the gap is too large, the conductivity decreases, and the photocurrent decreases.

The material of the sealing material is not particularly limited, but a material having light resistance, insulating property and moisture-proof property is preferable, and a variety of welding methods and an epoxy resin, an ultraviolet curable resin, an acryl resin, a polyisobutylene resin, ethylene vinyl acetate (EVA), an ionomer resin, a ceramic, a variety of thermal fusion resins and the like can be used. In addition, the location of the injection opening is not particularly limited as long as the location is neither on the semiconductor layer 3 nor on the counter electrode 6 which faces the semiconductor layer.

The method for injecting the electrolytic solution is not particularly limited, but a method, in which several drops of the solution are dropped on the injection opening, and introduced using a capillarity, is simple. In addition, it is also possible to carry out an injection operation under a reduced pressure or heating. After the solution is fully injected, the solution remaining at the injection opening is removed, and the injection opening is sealed. This sealing method is not particularly limited, and, if necessary, it is also possible to seal the injection opening by attaching the glass plate or the plastic substrate using a sealing material.

In addition, in a case in which the electrolyte is an electrolyte, which has been made to gelate using a polymer or the like, or an all-solid-state electrolyte, a polymer solution including the electrolyte and a plasticizer is coated on the semiconductor layer 3 using a casting method or the like. After that, the plasticizer is volatilized and fully removed, and the injection opening is sealed using a sealing material in the same manner as above. This sealing is preferably carried out using a vacuum sealer or the like in an inert gas atmosphere or during pressure reduction. After the injection opening is sealed, operations for heating and pressurization can also be carried out as necessary so that the electrolytic solution of the electrolyte layer 5 sufficiently intrudes into the semiconductor layer 3.

The dye-sensitized photoelectric conversion apparatus (dye-sensitized solar cell) based on the embodiment of the invention can be produced into a variety of shapes depending on the use, and the shape is not particularly limited.

Examples

<Production of a dye-sensitized solar cell>

(Example 1)

A paste-form dispersion fluid of titanium oxide $TiO_2$, which was a raw material when forming a semiconductor layer, was produced referring to "Recent Advances in Research and Development for Dye-Sensitized Solar Cells" (edited by Hironori Arakawa, 2001, CMC). That is, first, titanium isopropoxide (125 ml) was added dropwise gradually to 0.1 M nitric acid aqueous solution (750 ml) under stirring at room temperature. After the dropwise addition, the solution was moved to a constant-temperature tank at 80°C, and continuously stirred for 8 hours, thereby obtaining a translucent sol solution that became white turbid. This sol solution was cooled to room temperature, filtered using a glass filter, and then a solvent is added, thereby setting the volume of the solution to 700 ml. The obtained sol solution was moved to an autoclave, a hydrothermal reaction was caused at 220°C for 12 hours, and then an ultrasonic treatment was carried out for 1 hour, thereby carrying out a dispersing treatment. Next, the solution was condensed at 40°C using an evaporator, and prepared so that the amount of $TiO_2$ became 20 wt%. To this condensed sol solution, polyethylene glycol (molecular weight 500,000), corresponding to 20% of the mass of $TiO_2$, and anatase-type $TiO_2$ having a particle diameter of 200 nm, corresponding to 30% of the mass of $TiO_2$, were added, and uniformly mixed using a stirring defoaming device, thereby obtaining a paste-form dispersion fluid of $TiO_2$ having an increased viscosity.

The paste-form dispersion fluid of $TiO_2$ was coated on an FTO layer, which is the transparent electrode (transparent conductive layer), using the blade coating method, and a fine particle layer having a size of 5 mm × 5 mm and a thickness of 200 μm was formed. After that, the fine particle layer was held at 500°C for 30 minutes, and fine $TiO_2$ particles were sintered on the FTO layer. After that 0.1 M titanium chloride (IV) $TiCl_4$ aqueous solution was added dropwise to the sintered $TiO_2$ film, held at room temperature for 15 hours, then, washed, and sintered again at 500°C for 30 minutes. After that, ultraviolet rays were radiated on the $TiO_2$ sintered compact using an ultraviolet (UV) radiation apparatus for 30 minutes, impurities, such as organic substances included in the $TiO_2$ sintered compact, were oxidation-decomposed and removed using the catalytic action of $TiO_2$, and a treatment for increasing the activity of the $TiO_2$ sintered compact was carried out, thereby obtaining a semiconductor layer.

As a sensitizing dye, sufficiently purified di-tetrabutylammonium cis-bis(isothiocyanato)bis(2,2'-bipyridyl-4.4'-dicarboxylato)ruthenium (II) complex (N719, dye A1, 23.8 mg), which corresponds to the dye A, and 4-[5'-(N,N-di-4-methoxyphenyl)amino-3',4-di-n-hexyl-[2,2',5']-bithiophen-5-yl]pyridin e (dye B1, refer to Chem. 11, 2.5 mg), which corresponds to the dye B, were dissolved in a solvent mixture, in which acetonitrile, tert-butanol and tetrahydrofuran were mixed at a volume ratio of 1:1:1, (hereinafter referred to as "supporting solvent mixture", 50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. Next, the semiconductor layer was washed using an acetonitrile solution of 4-tert-butylpyridine (TBP) and acetonitrile sequentially, and then dried by evaporating the solvent at a dark place.

As an counter electrode, an electrode obtained by sequentially laminating a 500 Å-thick chromium layer and a 1000 Å-thick platinum layer on the FTO layer having a pre-formed 0.5 mm injection opening therein using the sputtering method, spray-coating an isopropyl alcohol (2-propanol) solution of platinum chloride acid on the platinum layer, and heating the solution at 385°C for 15 minutes, was used.

The semiconductor layer and the counter electrode, which were processed as described above, were disposed opposing each other, and the outer circumference was sealed using a 30 μm-thick ionomer resin film and an acryl-based ultraviolet curable resin.

Meanwhile, sodium iodide NaI (0.030 g), 1-propyl-2,3-dimethylimidazolium iodide (1.0 g), iodium $I_2$ (0.10 g) and TBP (0.054 g) were dissolved in methoxypropionitrile (2.0 g), thereby preparing an electrolytic solution.

This electrolytic solution was injected through the injection opening of the pre-prepared dye-sensitized solar cell using a tubing pump, and depressurized, thereby expelling air bubbles in the apparatus. Next, the injection opening was sealed using an ionomer resin film, an acryl resin and a glass substrate, thereby completing a dye-sensitized solar cell.

(Example 2)

As a sensitizing dye, sufficiently purified tri-tetrabutylammonium tris(isothiocyanato)(2,2':6',2"-terpyridine-4,4',4"-tricarboxylato)ruthenium (II) complex (black dye, dye A2, 25.5 mg) and a dye B1 (3.2 mg) were dissolved in the supporting solvent mixture (50 ml), thereby preparing a photosensitizing dye solution. Next, the semiconductor layer was immersed in the photosensitizing dye solution at room temperature for 72 hours, and the sensitizing dye was held on the surfaces of the fine $TiO_2$ particles. A dye-sensitized solar cell 10 was produced in the same manner as in Example 1 except for what is described above.

(Example 3)

As a sensitizing dye, two kinds of the dye A, which were a sufficiently purified dye A1 (8.9 mg) and a dye A2 (12.8 mg), and the dye B1 (1.6 mg) were dissolved in the supporting solvent mixture (50 ml), thereby preparing a photosensitizing dye solution.

Next, the semiconductor layer was immersed in the photosensitizing dye solution at room temperature for 48 hours, and the photosensitizing dye was held on the surfaces of the fine $TiO_2$ particles. A dye-sensitized solar cell was produced in the same manner as in Example 1 except for what is described above.

(Example 4)

To the dye of Example 3, sufficiently purified 4-[5'''-(9-ethyl-9H-carbazol-3-yl)-3',4-di-n-hexyl-[2,2',5']-bithiophen-5-yl]pyridine (dye B2, 1.6 mg) was further added so that the dye was configured to have both the dye A and the dye B containing two kinds of dyes respectively. These sensitizing dyes were dissolved in the supporting solvent mixture (50 ml), thereby preparing a photosensitizing dye solution.

Next, the semiconductor layer was immersed in the photosensitizing dye solution at room temperature for 72 hours, and the photosensitizing dye was held on the surfaces of the fine $TiO_2$ particles. A dye-sensitized solar cell was produced in the same manner as in Example 1 except for what is described above.

[Chem. 12] illustrates the structural formula of the dye B2.

[Chem. 12]

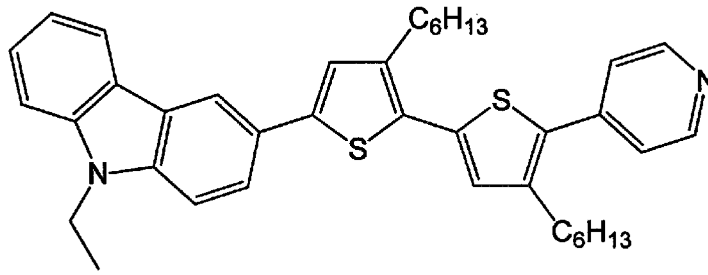

(Example 5)

As a sensitizing dye, two kinds of the dye A, which were a sufficiently purified dye A2 (12.8 mg) and a dye A3 (5.06 mg), and two kinds of the dye B, which were the dye B1 (1.6 mg) and the dye B2 (1.6 mg), were dissolved in the supporting solvent mixture (50 ml), thereby preparing a photosensitizing dye solution.

Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

[Chem. 13] illustrates the structural formula of the dye A3.

[Chem. 13]

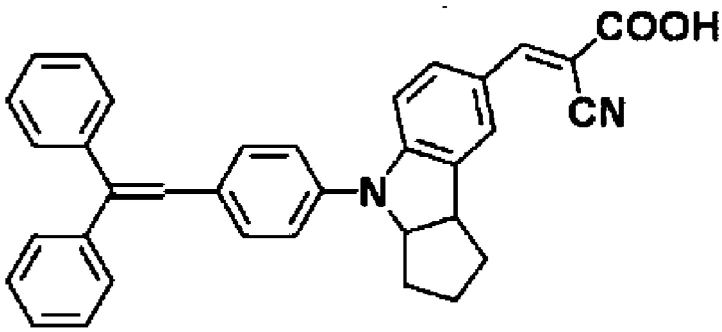

(Example 6)

The same amount of the same sensitizing dye as in Example 5 was dissolved in the supporting solvent mixture (50 ml), and chenodeoxycholic acid (392.6 mg) was added as an association inhibitor, thereby preparing a photosensitizing dye solution.

Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Example 7)

The same amount of the same sensitizing dye as in Example 4 was dissolved in the supporting solvent mixture (50 ml), and chenodeoxycholic acid (392.6 mg) was added as an association inhibitor, thereby preparing a photosensitizing dye solution.

Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Example 8)

As a sensitizing dye, the sufficiently purified dye A2 (12.8 mg) and the dye B1 (1.6 mg) were dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Example 9)

As a sensitizing dye, a sufficiently purified MK-2 (dye A4, 9.6 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 10)

As a sensitizing dye, a sufficiently purified dye A3 (5.1 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 11)

As a sensitizing dye, two kinds of the dye A, which were the sufficiently purified dye A3 (5.1 mg) and the dye A4 (9.6 mg), and the dye B1 (1.6 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 12)

As a sensitizing dye, two kinds of the dye A, which were the sufficiently purified dye A3 (5.1 mg) and the dye A4 (9.6 mg), and two kinds of the dye B, which were the dye B1 (1.6 mg) and the dye B2 (1.6 mg), were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 13)

The same amount of the same sensitizing dye as in Example 12 was dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 14)

As a sensitizing dye, the sufficiently purified dye A4 (9.6 mg) and the dye B1 (1.6 mg) were dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 24

hours, and the sensitizing dye was held on the surfaces of the fine $TiO_2$ particles. A dye-sensitized solar cell was produced in the same manner as in Example 1 except for what is described above.

(Example 15)

As a sensitizing dye, a sufficiently purified porphyrin P1 (dye A5, 5.0 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.
[Chem. 14] illustrates the structural formula of the dye A5.

[Chem. 14]

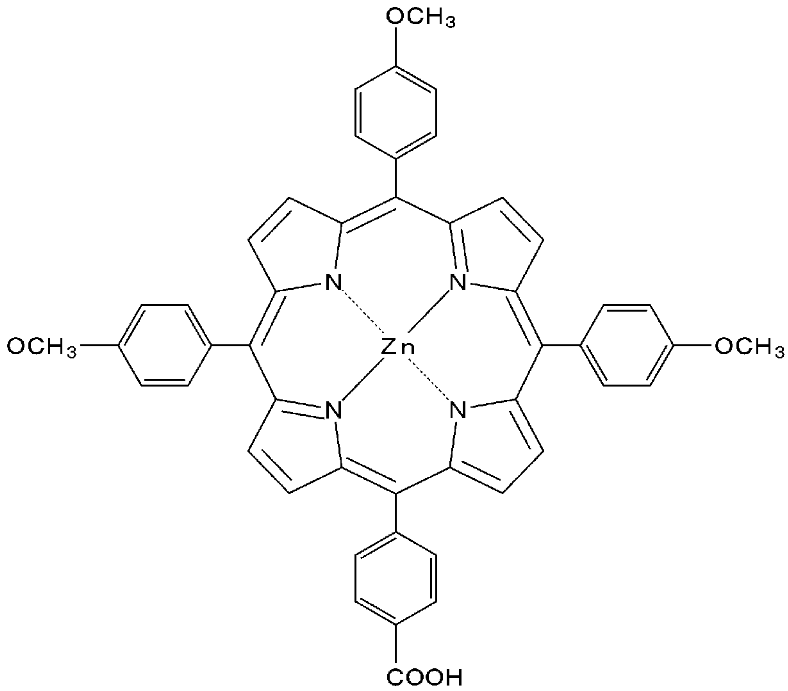

(Example 16)

As a sensitizing dye, a sufficiently purified porphyrin P2 (dye A6, 5.0 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.
[Chem. 15] illustrates the structural formula of the dye A6.

[Chem. 15]

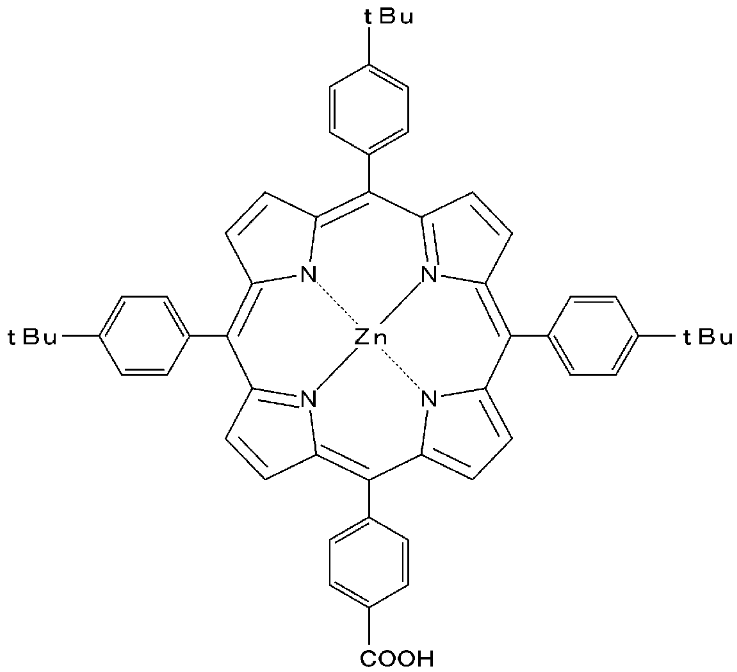

(Example 17)

As a sensitizing dye, two kinds of the dye A, which were the sufficiently purified dye A5 (2.5 mg) and the dye A6 (2.5 mg), and the dye B1 (3.2 mg) were dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 18)

As a sensitizing dye, two kinds of the dye A, which were the sufficiently purified dye A5 (2.5 mg) and the dye A6 (2.5 mg), and two kinds of the dye B, which were the dye B1 (3.2 mg) and the dye B2 (1.6 mg), were dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 19)

As a sensitizing dye, two kinds of the dye A, which were the sufficiently purified dye A3 (2.5 mg) and the dye A5 (2.5 mg), and two kinds of the dye B, which were the dye B1 (1.6 mg) and the dye B2 (1.6 mg), were dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 20)

The same amount of the same sensitizing dye as in Example 19 was dissolved in the supporting solvent mixture (50 ml), and chenodeoxycholic acid (392.6 mg) was added as an association inhibitor, thereby preparing a photosensitizing dye solution.

Next, the semiconductor layer was immersed in the photosensitizing dye solution at room temperature for 24

hours, and the sensitizing dye was held on the surfaces of the fine $TiO_2$ particles. A dye-sensitized solar cell was produced in the same manner as in Example 1 except for what is described above.

(Example 21)

The same amount of the same sensitizing dye as in Example 15 was dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 22)

As a sensitizing dye, a sufficiently purified phthalocyanine complex F1 (dye A7, 5.0 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.
[Chem. 16] illustrates the structural formula of the dye A7.

[Chem. 16]

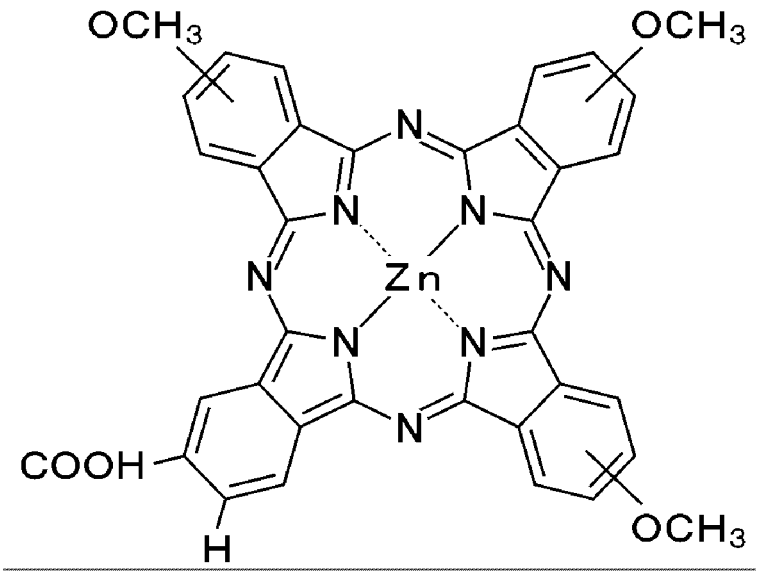

(Example 23)

As a sensitizing dye, a sufficiently purified phthalocyanine complex F2 (dye A8, 5.0 mg) and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.
[Chem. 17] illustrates the structural formula of the dye A8.

[Chem. 17]

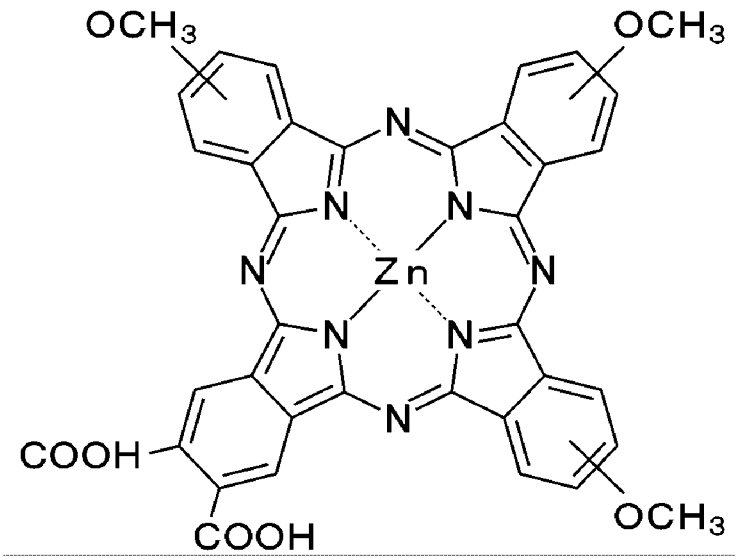

(Example 24)

As a sensitizing dye, two kinds of the dye A, which were the sufficiently purified dye A7 (2.5 mg) and the dye A8 (2.5 mg), and the dye B1 (3.2 mg) were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 25)

As a sensitizing dye, two kinds of the dye A, which were the sufficiently purified dye A7 (2.5 mg) and the dye A8 (2.5 mg), and two kinds of the dye B, which were the dye B1 (1.6 mg) and the dye B2 (1.6 mg), were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 26)

As a sensitizing dye, two kinds of the dye A, which were the sufficiently purified dye A3 (2.5 mg) and the dye A7 (2.5 mg), and two kinds of the dye B, which were the dye B1 (1.6 mg) and the dye B2 (1.6 mg), were dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 27)

The same amount of the same sensitizing dye as in Example 26 was dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 28)

The same amount of the same sensitizing dye as in Example 22 was dissolved in the supporting solvent mixture

(50 ml), and chenodeoxycholic acid (392.6 mg) was added as an association inhibitor, thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Example 29)

As a sensitizing dye, the sufficiently purified dye A2 (25.5 mg) and the dye B1 (3.2 mg) were dissolved in the supporting solvent mixture (50 ml), thereby preparing a photosensitizing dye solution.

Next, the semiconductor layer 3 was immersed in the photosensitizing dye solution at room temperature for 72 hours, and the sensitizing dye was held on the surfaces of the fine $TiO_2$ particles. After that, the semiconductor layer was washed using acetonitrile, and then dried by evaporating the solvent at a dark place.

As an electrolytic solution, a solution prepared by dissolving sodium iodide NaI (0.030 g), 1-propyl-2,3-dimethylimidazolium iodide (1.0 g) and iodium $I_2$ (0.10 g) in methoxypropionitrile (2.0 g), which did not include TBP, was used.

The dye-sensitized solar cell 10 was produced in the same manner as in Example 1 except for what is described above.

(Example 30)

As a sensitizing dye, the sufficiently purified dye A3 (5.1 mg) and the dye B 1 (3.2 mg) were dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. After that, the semiconductor layer was washed using acetonitrile, and then dried by evaporating the solvent at a dark place.

As an electrolytic solution, the same solution as in Example 29 was used.

The dye-sensitized solar cell was produced in the same manner as in Example 1 except for what is described above.

(Example 31)

As a sensitizing dye, the sufficiently purified dye A5 (5.0 mg) and the dye B1 (3.2 mg) were dissolved in the supporting solvent mixture (50 ml), thereby preparing a photosensitizing dye solution.

Next, the semiconductor layer 3 was immersed in the photosensitizing dye solution at room temperature for 24 hours, and the sensitizing dye was held on the surfaces of the fine $TiO_2$ particles. After that, the semiconductor layer was washed using acetonitrile, and then dried by evaporating the solvent at a dark place.

As an electrolytic solution, the same solution as in Example 29 was used.

The dye-sensitized solar cell was produced in the same manner as in Example 1 except for what is described above.

(Example 32)

As a sensitizing dye, the sufficiently purified dye A7 (5.0 mg) and the dye B1 (3.2 mg) were dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. After that, the semiconductor layer was washed using acetonitrile, and then dried by evaporating the solvent at a dark place.

As an electrolytic solution, the same solution as in Example 29 was used.

The dye-sensitized solar cell was produced in the same manner as in Example 1 except for what is described above.

As comparative examples, dye-sensitized solar cells, in which only one of the dye A and the dye B was used, were manufactured. The details of the respective comparative examples will be described below.

(Comparative Example 1)

As a sensitizing dye, only the sufficiently purified dye A1 (25.5 mg) was dissolved in the supporting solvent mixture (50 ml), thereby preparing a photosensitizing dye solution. Next, the semiconductor layer was immersed in the photosensitizing dye solution at room temperature for 72 hours, and the sensitizing dye was held on the surfaces of the

fine $TiO_2$ particles. A dye-sensitized solar cell was produced in the same manner as in Example 1 except for what is described above.

(Comparative Example 2)

As a sensitizing dye, only the sufficiently purified dye A2 (25.5 mg) was dissolved in the supporting solvent mixture (50 ml), thereby preparing a photosensitizing dye solution. Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Comparative Example 3)

As a sensitizing dye, only the sufficiently purified dye A2 (12.8 mg) was dissolved in the supporting solvent mixture (50 ml), and chenodeoxycholic acid (392.6 mg) was added as an association inhibitor, thereby preparing a photosensitizing dye solution.
Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Comparative Example 4)

As a sensitizing dye, only the sufficiently purified dye B1 (3.2 mg) was dissolved in the supporting solvent mixture (50 ml), thereby preparing a photosensitizing dye solution.
Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Comparative Example 5)

As a sensitizing dye, only the sufficiently purified dye B2 (3.2 mg) was dissolved in the supporting solvent mixture (50 ml), thereby preparing a photosensitizing dye solution.
Next, the semiconductor layer was immersed in the photosensitizing dye solution at room temperature for 72 hours, and the sensitizing dye was held on the surfaces of the fine $TiO_2$ particles. A dye-sensitized solar cell was produced in the same manner as in Example 1 except for what is described above.

(Comparative Example 6)

As a sensitizing dye, only the sufficiently purified dye A4 (9.6 mg) was dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Comparative Example 7)

As a sensitizing dye, only the sufficiently purified dye A3 (5.1 mg) was dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Comparative Example 8)

As a sensitizing dye, only the sufficiently purified dye A5 (5.0 mg) was dissolved in the supporting solvent mixture (50 ml), thereby preparing a photosensitizing dye solution.
Next, the semiconductor layer was immersed in the photosensitizing dye solution at room temperature for 24 hours, and the sensitizing dye was held on the surfaces of the fine $TiO_2$ particles. A dye-sensitized solar cell was produced

in the same manner as in Example 1 except for what is described above.

(Comparative Example 9)

As a sensitizing dye, only the sufficiently purified dye A6 (5.0 mg) was dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Comparative Example 10)

As a sensitizing dye, only the sufficiently purified dye A7 (5.0 mg) was dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

(Comparative Example 11)

As a sensitizing dye, only the sufficiently purified dye A8 (5.0 mg) was dissolved in the supporting solvent mixture (50 ml), thereby preparing a photosensitizing dye solution.

Next, the semiconductor layer was immersed in the photosensitizing dye solution at room temperature for 24 hours, and the sensitizing dye was held on the surfaces of the fine $TiO_2$ particles. A dye-sensitized solar cell was produced in the same manner as in Example 1 except for what is described above.

<Performance evaluation of the dye-sensitized solar cells>

For the dye-sensitized solar cells of Examples 1 to 32 and Comparative Examples 1 to 11, which were manufactured in the above manner, the open voltages, short-circuit currents in the current-voltage curve, fill factors and photoelectric conversion efficiencies under the radiation of pseudo solar light (AM 1.5, 100 mW/$cm^2$) were measured. The measurement results of Examples 1 to 14 are described in Table 1.

[Table 1]

| Example | Dye A | Dye B | Association inhibitor | TBP | Open voltage | Short-circuit current | Fill factor | Conversion efficiency |
|---|---|---|---|---|---|---|---|---|
| | | | | | V | mA/$cm^2$ | | % |
| 1 | A1 | B1 | × | ○ | 0.73 | 16.0 | 0.73 | 8.5 |
| 2 | A2 | B1 | × | ○ | 0.70 | 18.0 | 0.72 | 9.1 |
| 3 | A1, A2 | B1 | × | ○ | 0.70 | 19.2 | 0.72 | 9.7 |
| 4 | A1, A2 | B1, B2 | × | ○ | 0.70 | 19.5 | 0.72 | 9.8 |
| 5 | A2, A3 | B1, B2 | × | ○ | 0.70 | 18.2 | 0.72 | 9.2 |
| 6 | A2, A3 | B1, B2 | ○ | ○ | 0.70 | 19.5 | 0.72 | 9.8 |
| 7 | A1, A2 | B1, B2 | ○ | ○ | 0.70 | 19.7 | 0.72 | 9.9 |
| 8 | A2 | B1 | ○ | ○ | 0.70 | 18.2 | 0.72 | 9.2 |
| 9 | A4 | B1 | × | ○ | 0.72 | 12.8 | 0.70 | 6.5 |
| 10 | A3 | B1 | × | ○ | 0.72 | 12.8 | 0.70 | 6.5 |

(continued)

| Example | Dye A | Dye B | Association inhibitor | TBP | Open voltage | Short-circuit current | Fill factor | Conversion efficiency |
|---|---|---|---|---|---|---|---|---|
| | | | | | V | mA/cm$^2$ | | % |
| 11 | A3, A4 | B1 | × | ○ | 0.72 | 13.5 | 0.70 | 6.8 |
| 12 | A3, A4 | B1, B2 | × | ○ | 0.72 | 13.6 | 0.70 | 6.9 |
| 13 | A3, A4 | B1, B2 | ○ | ○ | 0.72 | 13.6 | 0.70 | 6.9 |
| 14 | A4 | B1 | ○ | ○ | 0.72 | 12.8 | 0.70 | 6.5 |

The measurement results of Examples 15 to 28 are described in Table 2.

[Table 2]

| Example | Dye A | Dye B | Association inhibitor | TBP | Open voltage | Short-circuit current | Fill factor | Conversion efficiency |
|---|---|---|---|---|---|---|---|---|
| | | | | | V | mA/cm$^2$ | | % |
| 15 | A5 | B1 | × | ○ | 0.70 | 10.5 | 0.69 | 5.1 |
| 16 | A6 | B1 | × | ○ | 0.65 | 9.8 | 0.69 | 4.4 |
| 17 | A5, A6 | B1 | × | ○ | 0.70 | 11.2 | 0.69 | 5.4 |
| 18 | A5, A6 | B1, B2 | × | ○ | 0.70 | 11.5 | 0.69 | 5.6 |
| 19 | A3, A5 | B1, B2 | × | ○ | 0.70 | 13.8 | 0.69 | 6.7 |
| 20 | A3, A5 | B1, B2 | ○ | ○ | 0.70 | 13.8 | 0.69 | 6.7 |
| 21 | A5 | B1 | ○ | ○ | 0.70 | 10.5 | 0.69 | 5.1 |
| 22 | A7 | B1 | × | ○ | 0.62 | 10.5 | 0.60 | 3.9 |
| 23 | A8 | B1 | × | ○ | 0.62 | 10.6 | 0.60 | 3.9 |
| 24 | A7, A8 | B1 | × | ○ | 0.62 | 10.9 | 0.60 | 4.1 |
| 25 | A7, A8 | B1, B2 | × | ○ | 0.62 | 11.2 | 0.60 | 4.2 |
| 26 | A3, A7 | B1, B2 | × | ○ | 0.72 | 13.0 | 0.60 | 5.6 |
| 27 | A3, A7 | B1, B2 | ○ | ○ | 0.72 | 13.0 | 0.60 | 5.6 |
| 28 | A7 | B1 | ○ | ○ | 0.62 | 10.5 | 0.60 | 3.9 |

The measurement results of Examples 29 to 32 are described in Table 3.

[Table 3]

| Example | Dye A | Dye B | Association inhibitor | TBP | Open voltage | Short-circuit current | Fill factor | Conversion efficiency |
|---|---|---|---|---|---|---|---|---|
| | | | | | V | mA/cm$^2$ | | % |
| 29 | A2 | B1 | × | × | 0.70 | 18.0 | 0.72 | 9.1 |
| 30 | A3 | B1 | × | × | 0.72 | 12.8 | 0.70 | 6.5 |
| 31 | A5 | B1 | × | × | 0.70 | 10.5 | 0.69 | 5.1 |
| 32 | A7 | B1 | × | × | 0.62 | 10.5 | 0.60 | 3.9 |

The measurement results of Comparative Examples 1 to 11 are described in Table 4.

[Table 4]

| Comparati ve Example | Dye A | Dye B | Association inhibitor | TBP | Open voltage | Short-circuit current | Fill factor | Conversion efficiency |
|---|---|---|---|---|---|---|---|---|
| | | | | | V | mA/cm$^2$ | | % |
| 1 | A1 | - | × | ○ | 0.68 | 12.1 | 0.68 | 5.6 |
| 2 | A2 | - | × | ○ | 0.66 | 14.0 | 0.70 | 6.5 |
| 3 | A2 | - | ○ | ○ | 0.67 | 16.0 | 0.70 | 7.5 |
| 4 | - | B1 | × | ○ | 0.60 | 7.0 | 0.60 | 2.5 |
| 5 | - | B2 | × | ○ | 0.60 | 6.5 | 0.60 | 2.3 |
| 6 | A4 | - | × | ○ | 0.72 | 10.0 | 0.70 | 5.0 |
| 7 | A3 | - | × | ○ | 0.72 | 9.8 | 0.70 | 4.9 |
| 8 | A5 | - | × | ○ | 0.70 | 8.8 | 0.69 | 4.3 |
| 9 | A6 | - | × | ○ | 0.65 | 7.6 | 0.69 | 3.4 |
| 10 | A7 | - | × | ○ | 0.62 | 7.5 | 0.60 | 2.8 |
| 11 | A8 | - | × | ○ | 0.62 | 7.4 | 0.60 | 2.8 |

Meanwhile, the fill factor in the respective tables is also called fill factor, and is a parameter that indicates a characteristic of a solar cell. In the current-voltage curve of an ideal photoelectric conversion apparatus, a constant output voltage as large as the open voltage is maintained until the output current reaches the same intensity as the short-circuit current; however, in an actual solar cell, the current-voltage curve has a different shape from the ideal current-voltage curve due to the internal resistance. The ratio of the area of a range surrounded by the actual current-voltage curve, the x axis and the y axis to the rectangular area of a range surrounded by the ideal current-voltage curve, the x axis and the y axis is referred to as filter factor. The fill factor indicates the degree of deviation from the ideal current-voltage curve, and thus is used to compute the actual photoelectric conversion efficiency.

As described in Tables 1 to 4, the photoelectric conversion efficiencies improved in the respective examples, in which the dye A and the dye B were included, compared to in the comparative examples, in which the same dye was used. While all the causes are not clearly understood, the major cause is as described above.

Thus far, the invention has been described based on the embodiments and the examples, but the invention is not limited to these examples, and it is needless to say that the invention can be appropriately modified within the scope of the claims.

Industrial Applicability

The invention can be applied to a dye-sensitized solar cell.

Reference Signs List

1 TRANSPARENT SUBSTRATE
2 TRANSPARENT ELECTRODE (NEGATIVE ELECTRODE)
3 SEMICONDUCTOR LAYER (SEMICONDUCTOR LAYER HOLDING PHOTOSENSITIZING DYE)
5 ELECTROLYTE LAYER
6 COUNTER ELECTRODE (POSITIVE ELECTRODE)
7 COUNTER SUBSTRATE
10 DYE-SENSITIZED SOLAR CELL

## Claims

1. A dye-sensitized solar cell comprising a semiconductor layer holding a photosensitizing dye, an electrolyte layer and a pair of electrodes, wherein
the photosensitizing dye includes a dye A having a carboxyl group or a phosphono group as a fixing group with the semiconductor layer, which bonds to a Brønsted acid group site in the semiconductor layer, and **characterised in that** the photosensitizing dye also includes a dye B having a nitrogen-containing aromatic heterocyclic compound as a fixing group with the semiconductor layer, which bonds to a Lewis acid group site in the semiconductor layer.

2. The dye-sensitized solar cell according to Claim 1,
wherein the nitrogen-containing aromatic heterocyclic compound includes at least one of a pyridine group, a pyridazine group, a pyrimidine group, 1,3,5-triazine group, an imidazole group, a pyrazole group, a thiazole group, a thiadiazole group, a triazole group, 1,8-naphthyridine group and a purine group.

3. The dye-sensitized solar cell according to Claim 1,
wherein the fixing group of the dye B also functions as an electron-accepting group.

4. The dye-sensitized solar cell according to any one of Claims 1 to 3, wherein the dye A is a polypyridyl complex.

5. The dye-sensitized solar cell according to Claim 4, wherein a metal used in the polypyridyl complex is ruthenium or osmium.

6. The dye-sensitized solar cell according to any one of Claims 1 to 3, wherein the dye A is a phthalocyanine complex.

7. The dye-sensitized solar cell according to Claim 6, wherein a central metal of the phthalocyanine complex is any of zinc, iron, tin and copper.

8. The dye-sensitized solar cell according to any one of Claims 1 to 3, wherein the dye A includes porphyrin.

9. The dye-sensitized solar cell according to any one of Claims 1 to 3, wherein the dye A is an organic dye having a carboxyl group as the fixing group.

10. The dye-sensitized solar cell according to Claim 9, wherein the carboxyl group is cyanoacrylate.

11. The dye-sensitized solar cell according to any one of Claims 1 to 10, wherein in at least any one of the dye A and the dye B, an electron-donating group and the electron-accepting group are linked directly or through a linking group.

12. The dye-sensitized solar cell according to Claim 11, wherein the linking group is any of N-alkyl carbazole group, 9,9-dialkyl fluorene group, a thiophene group and an oligothiophene group.

13. The dye-sensitized solar cell according to Claim 12, wherein in at least one of the dye A and the dye B, the electron-donating group is any of a pyrrole group, an isothianaphthene group, a diphenylamine group, a di(4-alkoxyphenyl)amine group and a carbazole group.

14. The dye-sensitized solar cell according to any one of Claims 1 to 13, wherein a thickness of the semiconductor layer

is in a range of 0.1 μm to 50 μm.

**15.** The dye-sensitized solar cell according to any one of Claims 1 to 14, wherein the semiconductor layer includes $TiO_2$.

**16.** The dye-sensitized solar cell according to Claim 15, wherein the $TiO_2$ is anatase $TiO_2$.

**17.** The dye-sensitized solar cell according to any one of Claims 1 to 16, wherein the electrolyte layer is configured of an electrolytic solution, a gel or solid-form electrolyte.

**18.** The dye-sensitized solar cell according to any one of Claims 1 to 17, wherein a molecular weight of the dye B is 200 or more.

**Patentansprüche**

**1.** Farbstoffsensibilisierte Solarzelle, umfassend eine Halbleiterschicht, die einen photosensibilisierenden Farbstoff, eine Elektrolytschicht und ein Paar Elektroden hält, wobei
der photosensibilisierende Farbstoff einen Farbstoff A umfasst, der eine Carboxylgruppe oder eine Phosphonogruppe als Fixiergruppe mit der Halbleiterschicht umfasst, die sich an eine Brønstedsäuregruppenstelle in der Halbleiterschicht bindet, und **dadurch gekennzeichnet ist, dass** der photosensibilisierende Farbstoff auch einen Farbstoff B umfasst, der eine stickstoffhaltige aromatische heterocyclische Verbindung als Fixiermittel mit der Halbleiterschicht umfasst, die sich an eine Lewis-Säuregruppenstelle in der Halbleiterschicht bindet.

**2.** Farbstoffsensibilisierte Solarzelle nach Anspruch 1,
wobei die stickstoffhaltige aromatische heterocyclische Verbindung mindestens eine umfasst von einer Pyridingruppe, einer Pyridazingruppe, einer Pyrimidingruppe, 1,3,5-Triazingruppe, einer Imidazolgruppe, einer Pyrazolgruppe, einer Thiazolgruppe, einer Thiadiazolgruppe, einer Triazolgruppe, einer 1,8-Naphthyridingruppe und einer Puringruppe.

**3.** Farbstoffsensibilisierte Solarzelle nach Anspruch 1,
wobei die Fixiergruppe des Farbstoffs B auch als elektronenakzeptierende Gruppe funktioniert.

**4.** Farbstoffsensibilisierte Solarzelle nach einem der Ansprüche 1 bis 3, wobei der Farbstoff A ein Polypyridylkomplex ist.

**5.** Farbstoffsensibilisierte Solarzelle nach Anspruch 4, wobei ein Metall, das in dem Polypyridylkomplex verwendet wird, Ruthenium oder Osmium ist.

**6.** Farbstoffsensibilisierte Solarzelle nach einem der Ansprüche 1 bis 3, wobei der Farbstoff A ein Phthalocyaninkomplex ist.

**7.** Farbstoffsensibilisierte Solarzelle nach Anspruch 6, wobei ein zentrales Metall des Phthalocyaninkomplexes irgendeines von Zink, Eisen, Zinn und Kupfer ist.

**8.** Farbstoffsensibilisierte Solarzelle nach einem der Ansprüche 1 bis 3, wobei der Farbstoff A Porphyrin umfasst.

**9.** Farbstoffsensibilisierte Solarzelle nach einem der Ansprüche 1 bis 3, wobei der Farbstoff A ein organischer Farbstoff ist, der eine Carboxylgruppe als Fixiergruppe aufweist.

**10.** Farbstoffsensibilisierte Solarzelle nach Anspruch 9, wobei die Carboxylgruppe Cyanoacrylat ist.

**11.** Farbstoffsensibilisierte Solarzelle nach einem der Ansprüche 1 bis 10, wobei in mindestens irgendeinem von dem Farbstoff A und dem Farbstoff B eine elektronenspendende Gruppe ist und die elektronenakzeptierende Gruppe direkt oder durch eine Verknüpfungsgruppe verknüpft sind.

**12.** Farbstoffsensibilisierte Solarzelle nach Anspruch 11, wobei die Verknüpfungsgruppe irgendeine von einer N-Alkylcarbazolgruppe, einer 9,9-Dialkylfluorengruppe, einer Thiophengruppe und einer Oligothiophengruppe ist.

**13.** Farbstoffsensibilisierte Solarzelle nach Anspruch 12, wobei in mindestens einem des Farbstoffs A und des Farbstoffs

B die elektronenspendende Gruppe irgendeine ist von einer Pyrrolgruppe, einer Isothianaphthengruppe, einer Diphenylamingruppe, einer Di(4-Alkoxyphenyl)amingruppe und einer Carbazolgruppe.

**14.** Farbstoffsensibilisierte Solarzelle nach einem der Ansprüche 1 bis 13, wobei eine Dicke der Halbleiterschicht in einem Bereich von 0,1 μm bis 50 μm liegt.

**15.** Farbstoffsensibilisierte Solarzelle nach einem der Ansprüche 1 bis 14, wobei die Halbleiterschicht $TiO_2$ umfasst.

**16.** Farbstoffsensibilisierte Solarzelle nach Anspruch 15, wobei das $TiO_2$ Anatas-$TiO_2$ ist.

**17.** Farbstoffsensibilisierte Solarzelle nach einem der Ansprüche 1 bis 16, wobei die Elektrolytschicht aus einer elektrolytischen Lösung, einem Gel- oder Feststoffform-Elektrolyt konfiguriert ist.

**18.** Farbstoffsensibilisierte Solarzelle nach einem der Ansprüche 1 bis 17, wobei ein Molekulargewicht des Farbstoffs B 200 oder mehr beträgt.

## Revendications

**1.** Pile solaire à pigment photosensible comprenant une couche semi-conductrice maintenant un colorant photosensibilisant, une couche d'électrolyte et une paire d'électrodes,
le colorant photosensibilisant incluant un colorant A ayant un groupe carboxyle ou un groupe phosphono comme groupe fixant avec la couche semi-conductrice, qui se lie à un site de groupe acide de Brønsted dans la couche semi-conductrice, et **caractérisé en ce que** le colorant photosensibilisant inclut également un colorant B ayant un composé hétérocyclique aromatique contenant de l'azote comme groupe fixant avec la couche semi-conductrice, qui se lie à un site de groupe acide de Lewis dans la couche semi-conductrice.

**2.** Pile solaire à pigment photosensible selon la revendication 1,
le composé hétérocyclique aromatique contenant de l'azote incluant au moins l'un parmi un groupe pyridine, un groupe pyridazine, un groupe pyrimidine, un groupe 1,3,5-triazine, un groupe imidazole, un groupe pyrazole, un groupe thiazole, un groupe thiadiazole, un groupe triazole, un groupe 1,8-naphtyridine et un groupe purine.

**3.** Pile solaire à pigment photosensible selon la revendication 1,
le groupe fixant du colorant B fonctionnant également comme groupe accepteur d'électrons.

**4.** Pile solaire à pigment photosensible selon l'une quelconque des revendications 1 à 3, le colorant A étant un complexe polypyridyle.

**5.** Pile solaire à pigment photosensible selon la revendication 4, un métal utilisé dans le complexe polypyridyle étant le ruthénium ou l'osmium.

**6.** Pile solaire à pigment photosensible selon l'une quelconque des revendications 1 à 3, le colorant A étant un complexe phtalocyanine.

**7.** Pile solaire à pigment photosensible selon la revendication 6, un métal central du complexe phtalocyanine étant n'importe lequel parmi le zinc, le fer, l'étain et le cuivre.

**8.** Pile solaire à pigment photosensible selon l'une quelconque des revendications 1 à 3, le colorant A incluant de la porphyrine.

**9.** Pile solaire à pigment photosensible selon l'une quelconque des revendications 1 à 3, le colorant A étant un colorant organique ayant un groupe carboxyle comme groupe fixant.

**10.** Pile solaire à pigment photosensible selon la revendication 9, le groupe carboxyle étant un cyanoacrylate.

**11.** Pile solaire à pigment photosensible selon l'une quelconque des revendications 1 à 10, dans laquelle dans au moins n'importe lequel du colorant A et du colorant B, un groupe donneur d'électrons et le groupe accepteur d'électrons sont liés directement ou à travers un groupe de liaison.

**12.** Pile solaire à pigment photosensible selon la revendication 11, le groupe de liaison étant n'importe lequel d'un groupe N-alkyl carbazole, d'un groupe 9,9-dialkyl fluorène, d'un groupe thiophène et d'un groupe oligothiophène.

**13.** Pile solaire à pigment photosensible selon la revendication 12, dans laquelle dans au moins l'un du colorant A et du colorant B, le groupe donneur d'électrons est n'importe lequel d'un groupe pyrrole, d'un groupe isothianaphtène, d'un groupe diphénylamine, d'un groupe di(4-alcoxyphényl)amine et d'un groupe carbazole.

**14.** Pile solaire à pigment photosensible selon l'une quelconque des revendications 1 à 13, dans laquelle une épaisseur de la couche semi-conductrice se situe dans une plage de 0,1 μm à 50 μm.

**15.** Pile solaire à pigment photosensible selon l'une quelconque des revendications 1 à 14, dans laquelle la couche semi-conductrice inclut du $TiO_2$.

**16.** Pile solaire à pigment photosensible selon la revendication 15, dans laquelle le $TiO_2$ est le $TiO_2$ anatase.

**17.** Pile solaire à pigment photosensible selon l'une quelconque des revendications 1 à 16, dans laquelle la couche d'électrolyte est configurée à partir d'une solution électrolytique, d'un électrolyte sous forme de gel ou sous forme solide.

**18.** Pile solaire à pigment photosensible selon l'une quelconque des revendications 1 à 17, dans laquelle un poids moléculaire du colorant B est de 200 ou plus.

FIG. 1

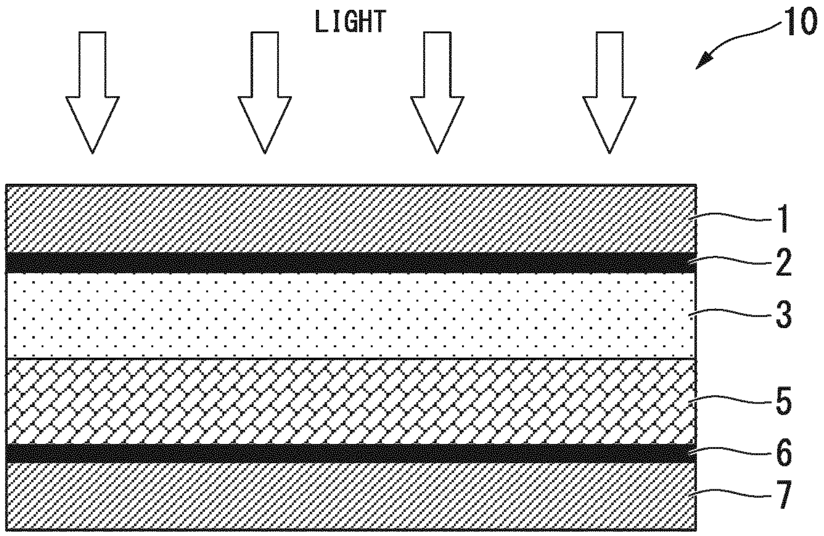
LIGHT
10
1
2
3
5
6
7

FIG. 2

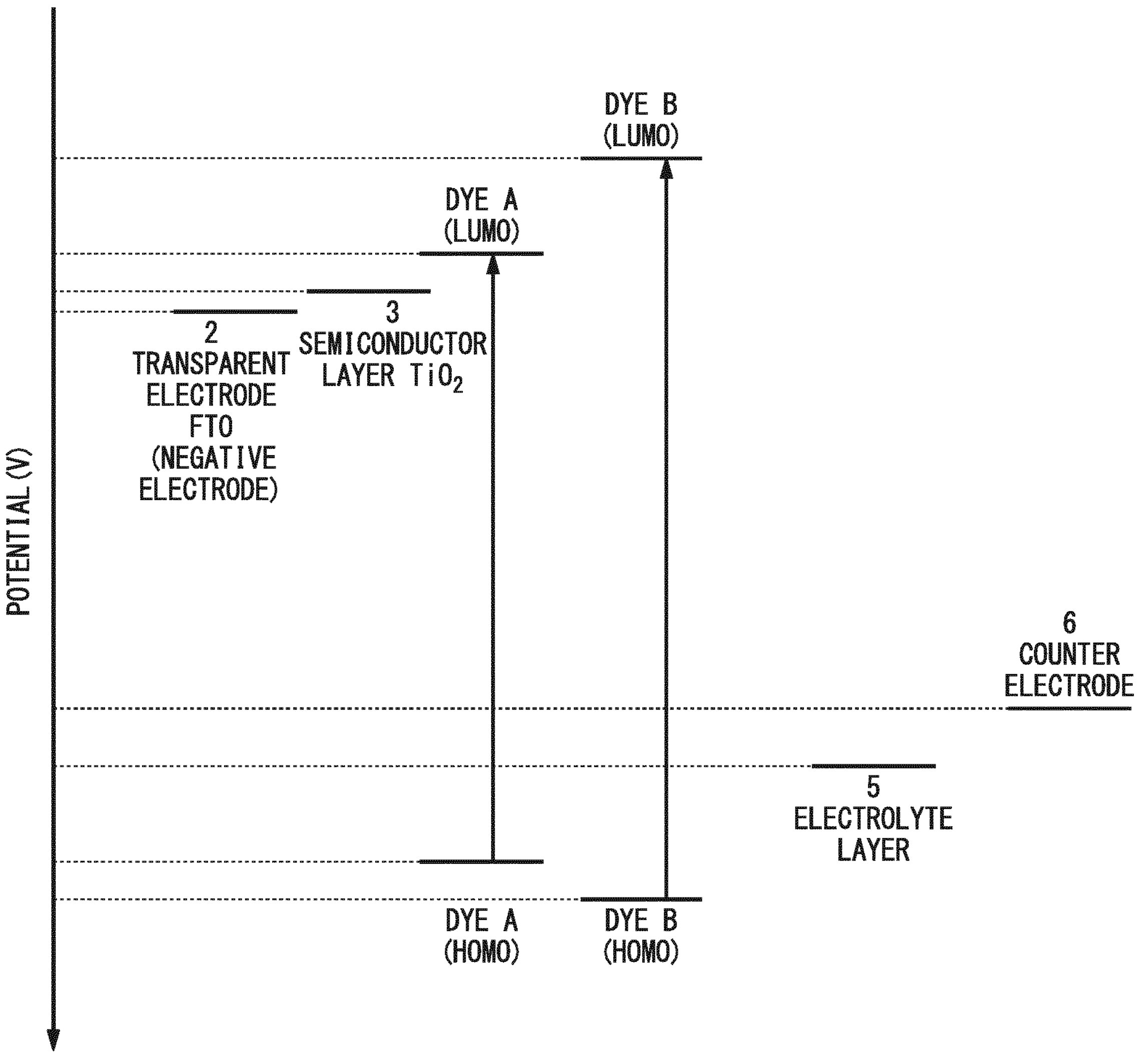
POTENTIAL (V)
DYE B (LUMO)
DYE A (LUMO)
2 TRANSPARENT ELECTRODE FTO (NEGATIVE ELECTRODE)
3 SEMICONDUCTOR LAYER $TiO_2$
6 COUNTER ELECTRODE
5 ELECTROLYTE LAYER
DYE A (HOMO)
DYE B (HOMO)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2664194 B
- JP 4380779 B
- JP 2007234580 B


### Non-patent literature cited in the description


- **NAOYUKI SHIBAYAMA et al.** Sensitizing dye β - The influence of the fluorine substitution of diketonate terpyridine Ru complex on battery performance. *74th Annual Meeting of the Electrochemical Society of Japan,* 2007, PS06